# EUROPEAN PATENT SPECIFICATION

(11) **EP 4 560 614 B1**
(45) Date of publication and mention of the grant of the patent: **22.07.2026**
(21) Application number: 22960219.8
(22) Date of filing: 30.09.2022
(51) Int. Cl.: G09G 3/32, H10K 59/131, H10D 86/40

(54) **DISPLAY PANEL AND DISPLAY APPARATUS**
ANZEIGETAFEL UND ANZEIGEVORRICHTUNG
ÉCRAN D'AFFICHAGE ET APPAREIL D'AFFICHAGE

(43) Date of publication of application: 28.05.2025
(73) Proprietor: Boe Technology Group Co., Ltd., Beijing 100015 (CN); Chengdu BOE Optoelectronics Technology Co., Ltd., Chengdu, Sichuan 611731 (CN)
(72) Inventor: LIU, Biao, Beijing 100176 (CN); SHANG, Tinghua, Beijing 100176 (CN); LONG, Yixuan, Beijing 100176 (CN); NIU, Zuoji, Beijing 100176 (CN); CHEN, Jiaxing, Beijing 100176 (CN); ZHOU, Yang, Beijing 100176 (CN); ZHANG, Yi, Beijing 100176 (CN)
(74) Representative: Potter Clarkson
(86) International application number: PCT/CN2022/123046
(87) International publication number: WO 2024/065591

(56) References cited:
- WO-A1-2022/188374
- CN-A- 110 634 884
- CN-A- 113 707 704
- CN-A- 114 122 101
- CN-A- 114 222 615
- JP-A- 2010 161 084
- KR-A- 20210 083 679
- US-B2- 11 244 620

## Description

### TECHNICAL FIELD

The present disclosure relates to the field of display technology, and in particular to a display panel and a display device.

### BACKGROUND

In the related art, when driven by the same data signal, at least some of the different sub-pixels have different luminous brightness. WO2022188374 A1 discloses an array substrate and a display panel comprising a plurality of pixel driving circuits, known from the prior art.

It should be noted that the information disclosed in the above background section is only used to enhance the understanding of the background of the present disclosure, and therefore may include information that does not constitute prior art known to those of ordinary skills in the art.

### SUMMARY

The subject matter of the present invention is defined in claim 1. According to an aspect of the present disclosure, a display panel is provided, The display panel includes a plurality of pixel driving circuits. The pixel driving circuits includes a driving transistor and a fourth transistor. The fourth transistor has a first terminal connected to a data line, a second terminal connected to the first terminal of the driving transistor, and a gate connected to a first gate line. The plurality of pixel driving circuits includes a first pixel driving circuit and a second pixel driving circuit. The capacitance formed by the first gate line and the equipotential structure of the gate of the driving transistor in the first pixel driving circuit is C1, and the capacitance formed by the first gate line and the equipotential structure of the gate of the driving transistor in the second pixel driving circuit is C2, where C1 is not equal to C2.

In an exemplary embodiment of the present disclosure, the display panel further includes a plurality of light-emitting units. The plurality of light-emitting units includes a first light-emitting unit and a second light-emitting unit. The first pixel driving circuit is used to drive the first light-emitting unit, and the second pixel driving circuit is used to drive the second light-emitting unit. With the same driving current, the brightness of the first light-emitting unit is less than the brightness of the second light-emitting unit, and C1 is less than C2.

In an exemplary embodiment of the present disclosure, the display panel further includes: a base substrate, a first active layer, a first conductive layer, and a second conductive portion. The first active layer is located on a side of the base substrate. The first active layer includes a third active portion, and the third active portion is used to form the channel region of the driving transistor. The first conductive layer is located on the side of the first active layer away from the base substrate. The first conductive layer includes a first conductive portion. The orthographic projection of the first conductive portion on the base substrate covers the orthographic projection of the third active portion on the base substrate. The first conductive portion is used to form the gate of the driving transistor. The second conductive portion is arranged corresponding to the first conductive portion. The second conductive portion is connected to the first conductive portion corresponding thereto. The overlap area between the orthographic projection on the base substrate of the first gate line and the orthographic projection on the base substrate of the second conductive portion in the first pixel driving circuit is S1. The overlap area between the orthographic projection on the base substrate of the first gate line and the orthographic projection on the base substrate of the second conductive portion in the second pixel driving circuit is S2. S1 is less than S2.

In an exemplary embodiment of the present disclosure, the pixel driving circuit further includes an eighth transistor. The first terminal of the eighth transistor is connected to the gate of the driving transistor. The display panel further includes a second active layer. The second active layer is located on the side of the first conductive layer away from the base substrate. The second active layer includes an eighth active portion and a ninth active portion connected to each other. The eighth active portion is used to form the channel region of the eighth transistor. The ninth active portion is connected to the first conductive portion. The second conductive portion includes the ninth active portion. The overlap area between the orthographic projection on the base substrate of the first gate line and the orthographic projection on the base substrate of the ninth active portion in the first pixel driving circuit is smaller than the overlap area between the orthographic projection on the base substrate of the first gate line and the orthographic projection on the base substrate of the ninth active portion in the second pixel driving circuit.

In an exemplary embodiment of the present disclosure, the first conductive layer includes the first gate line, and the orthographic projection of the first gate line on the base substrate extends along the first direction. The first gate line includes a plurality of first extension portions and a plurality of second extension portions. The orthographic projections of the plurality of first extension portions on the base substrate extend along the first direction and are spaced apart along the first direction. The second extension portion is connected between adjacent first extension portions in the first direction. The size in the second direction of the orthographic projection of the first extension portion on the base substrate is smaller than the size in the second direction of the orthographic projection of the second extension portion on the base substrate. The first direction and the second direction intersect. The orthographic projection of the second conductive portion on the base substrate and the orthographic projection of the second extension portion on the base substrate at least partially overlap.

In an exemplary embodiment of the present disclosure, the pixel driving circuit further includes an eighth transistor. The first terminal of the eighth transistor is connected to the gate of the driving transistor. The display panel further includes a second active layer. The second active layer is located on the side of the first conductive layer away from the base substrate. The second active layer includes an eighth active portion and a ninth active portion connected to each other. The eighth active portion is used to form the channel region of the eighth transistor. The ninth active portion is connected to the first conductive portion. The second conductive portion includes the ninth active portion. The orthographic projection of the ninth active portion on the base substrate is located on the orthographic projection of the second extension portion on the base substrate. The size in the first direction of the orthographic projection on the base substrate of the ninth active portion in the first pixel driving circuit is smaller than the size in the first direction of the orthographic projection on the base substrate of the ninth active portion in the second pixel driving circuit.

In an exemplary embodiment of the present disclosure, the first light-emitting unit is a blue light-emitting unit, and the second light-emitting unit is a red light-emitting unit or a green light-emitting unit.

In an exemplary embodiment of the present disclosure, the plurality of pixel driving circuits is arrayed along the first direction and the second direction, and the display panel further includes a base substrate, a fourth conductive layer, and a fifth conductive layer. The fourth conductive layer is located on one side of the base substrate. The fourth conductive layer includes a plurality of first power line segments. The first power line segments are arranged corresponding to the pixel driving circuits. The orthographic projections of the plurality of first power line segments on the base substrate are arrayed along the first direction and the second direction and extend along the second direction. The first direction and the second direction intersect. The first power line segments are connected to a stable voltage source. The fifth conductive layer is located on the side of the fourth conductive layer away from the base substrate. The fifth conductive layer includes the data line. The orthographic projection of the data line on the base substrate extends along the second direction.

In an exemplary embodiment of the present disclosure, the pixel driving circuit further includes an eighth transistor, the first terminal of the eighth transistor is connected to the gate of the driving transistor, and the display panel further includes a second active layer and a third conductive layer. The second active layer is located between the fourth conductive layer and the base substrate. The second active layer includes an eighth active portion, and the eighth active portion is used to form the channel region of the eighth transistor. The third conductive layer is located between the second active layer and the fourth conductive layer. The third conductive layer includes a second gate line. The orthographic projection of the second gate line on the base substrate extends along the first direction, and covers the orthographic projection of the eighth active portion on the base substrate. A partial structure of the second gate line is used to form the top gate of the eighth transistor. The orthographic projection of the first power line segment on the base substrate is located between the orthographic projections of two adjacent second gate lines on the base substrate.

In an exemplary embodiment of the present disclosure, the display panel also includes a source driving circuit. A signal output terminal of the source driving circuit is connected to the plurality of data lines. A signal output terminal of the source driving circuit provides data signals to the plurality of data lines in a time-division way within a row scanning cycle. The first power line segment includes a third extension portion. The orthographic projection of the third extension portion on the base substrate and the orthographic projection of the data line on the base substrate at least partially overlap.

In an exemplary embodiment of the present disclosure, the orthographic projection of the data line on the base substrate has an area of S3, and the overlap area between the orthographic projection of the data line on the base substrate and the orthographic projection of the third extension portion on the base substrate is S4, where S4/S3 is greater than or equal to 20% and less than or equal to 70%.

In an exemplary embodiment of the present disclosure, the first terminal of the driving transistor is connected to the power line. The fourth conductive layer further includes a first connecting portion. The first connecting portion is connected between two adjacent first power line segments in the first direction. The fifth conductive layer further includes the power line. The orthographic projection of the power line on the base substrate extends along the second direction. The power line is used to provide the stable voltage source.

In an exemplary embodiment of the present disclosure, the first power line segment further includes a fourth extension portion. The display panel further includes a second conductive portion. The second conductive portion is connected to the gate of the driving transistor. The orthographic projection of the fourth extension portion on the base substrate extends along the second direction, and is located between the orthographic projection of the data line on the base substrate and the orthographic projection of the second conductive portion on the base substrate.

In an exemplary embodiment of the present disclosure, the display panel further includes a second conductive portion. The second conductive portion is connected to the gate of the driving transistor. The first power line segment further includes a third extension portion. The third extension portion is connected to the fourth extension portion. The size in the first direction of the orthographic projection of the third extension portion on the base substrate is larger than the size in the first direction of the orthographic projection of the fourth extension portion on the base substrate. The orthographic projection of a partial structure of the third extension portion on the base substrate is located between the orthographic projection of the second conductive portion on the base substrate and the orthographic projection of the data line on the base substrate.

In an exemplary embodiment of the present disclosure, the first terminal of the driving transistor is connected to the power line. The pixel driving circuit further includes an eighth transistor, and the first terminal of the eighth transistor is connected to the gate of the driving transistor. The display panel further includes a base substrate, a second active layer, and a fifth conductive layer. The second active layer is located on one side of the base substrate. The second active layer includes an active portion. A partial structure of the active portion is used to form the channel region of the eighth transistor. The fifth conductive layer is located on the side of the second active layer away from the base substrate. The fifth conductive layer includes the power line. The orthographic projection of the power line on the base substrate covers the orthographic projection of the active portion on the base substrate.

In an exemplary embodiment of the present disclosure, the first terminal of the driving transistor is connected to a power line, and the display panel further includes a base substrate, a second conductive portion, and a fifth conductive layer. The second conductive portion is connected to the gate of the driving transistor. The fifth conductive layer is located on one side of the base substrate. The fifth conductive layer includes the power line. The orthographic projection of the power line on the base substrate covers the orthographic projection of the second conductive portion on the base substrate.

In an exemplary embodiment of the present disclosure, the first terminal of the driving transistor is connected to the power line, and the display panel further includes a base substrate, a fifth conductive layer, an electrode layer, and a pixel definition layer. The fifth conductive layer is located on one side of the base substrate. The fifth conductive layer includes the power line and the data line. The orthographic projection of the power line on the base substrate and the orthographic projection of the data line on the base substrate extend along the second direction. The electrode layer includes a plurality of electrode portions. The orthographic projection of the electrode portion on the base substrate overlaps with the orthographic projection of the power line on the base substrate and the orthographic projection of the data line on the base substrate. The pixel definition layer is located on the side of the electrode layer away from the base substrate. A pixel opening used for forming a light-emitting unit is provided on the pixel definition layer. The orthographic projection of the pixel opening on the base substrate coincides with the orthographic projection of the electrode portion on the base substrate.

In an exemplary embodiment of the present disclosure, the electrode portion includes a first part and a second part. The orthographic projection of the first part on the base substrate and the orthographic projection of the second part on the base substrate are arranged along a first direction. The maximum size in the first direction of the orthographic projection of the first part on the base substrate is equal to the maximum size in the first direction of the orthographic projection of the second part on the base substrate. The first direction and the second direction intersect. The orthographic projection of the first part on the base substrate and the orthographic projection of the power line on the base substrate at least partially overlap. The orthographic projection of the second part on the base substrate and the orthographic projection of the data line on the base substrate at least partially overlap.

In an exemplary embodiment of the present disclosure, the minimum size in the first direction of the overlap area between the orthographic projection of the electrode portion on the base substrate and the orthographic projection of the power line on the base substrate is L1, and the minimum size in the first direction of the orthographic projection of the data line on the base substrate is L2, where L1 is greater than L2.

In an exemplary embodiment of the present disclosure, the display panel further includes a plurality of light-emitting units, including a first light-emitting unit and a second light-emitting unit. The first pixel driving circuit is used to drive the first light-emitting unit, and the second pixel driving circuit is used to drive the second light-emitting unit. The voltage required for the first light-emitting unit to emit light is greater than the voltage required for the second light-emitting unit to emit light. The width-to-length ratio of the channel region of the driving transistor in the first pixel driving circuit is greater than the width-to-length ratio of the channel region of the driving transistor in the second pixel driving circuit.

In an exemplary embodiment of the present disclosure, the length of the channel region of the driving transistor in the first pixel driving circuit is less than the length of the channel region of the driving transistor in the second pixel driving circuit.

In an exemplary embodiment of the present disclosure, the display panel also includes a light-emitting unit, and the pixel driving circuit is used to drive the light-emitting unit to emit light. The pixel driving circuit also includes: an eighth transistor, a first transistor, a second transistor, a fifth transistor, a sixth transistor, a seventh transistor, and a capacitor. The eighth transistor has the first terminal connected to the gate of the driving transistor, and the gate connected to the second gate line. The first transistor has the first terminal connected to the first initial signal line, the second terminal connected to the second terminal of the eighth transistor, and the gate connected to the first reset signal line. The second transistor has the first terminal connected to the second terminal of the eighth transistor, the second terminal connected to the second terminal of the driving transistor, and the gate connected to the first gate line. The fifth transistor has the first terminal connected to the power line, the second terminal connected to the first terminal of the driving transistor, and the gate connected to the enable signal line. The sixth transistor has the first terminal connected to the second terminal of the driving transistor, the second terminal connected to the first electrode of the light-emitting unit, and the gate connected to the enable signal line. The seventh transistor has the first terminal connected to the second initial signal line, the second terminal connected to the first electrode of the light-emitting unit, and the gate connected to the second reset signal line. The capacitor is connected between the gate of the driving transistor and the power line.

In an exemplary embodiment of the present disclosure, the display panel further comprises a base substrate, a first active layer, a first conductive layer, a second active layer, and a third conductive layer. The first active layer is located on one side of the base substrate. The first active layer comprises a first active portion, a second active portion, a third active portion, a fourth active portion, a fifth active portion, a sixth active portion, and a seventh active portion. The first active portion is used to form the channel region of the first transistor. The second active portion is used to form the channel region of the second transistor. The third active portion is used to form the channel region of the driving transistor. The fourth active portion is used to form the channel region of the fourth transistor. The fifth active portion is used to form the channel region of the fifth transistor. The sixth active portion is used to form the channel region of the sixth transistor. The seventh active portion is used to form the channel region of the seventh transistor. The first conductive layer includes the first gate line, the first reset signal line, the second reset signal line, the enable signal line, and the first conductive portion. The orthographic projections of the first gate line, the first reset signal line, the second reset signal line, and the enable signal line on the base substrate all extend along the first direction. A partial structure of the first gate line is used to form the gates of the second transistor and the fourth transistor respectively. A partial structure of the enable signal line is used to form the gates of the fifth transistor and the sixth transistor respectively. A partial structure of the first reset signal line is used to form the gate of the first transistor. A partial structure of the second reset signal line is used to form the gate of the seventh transistor. The first conductive portion is used to form the gate of the driving transistor. The second active layer is located on the side of the first conductive layer away from the base substrate. The second active layer includes the eighth active portion. The eighth active portion is used to form the channel region of the eighth transistor. The third conductive layer is located on the side of the second active layer away from the base substrate. The third conductive layer includes the second gate line. A partial structure of the second gate line is used to form the top gate of the eighth transistor. The orthographic projection of the first conductive portion on the base substrate is located between the orthographic projection of the first gate line on the base substrate and the orthographic projection of the enable signal line on the base substrate. The orthographic projection of the first reset signal line on the base substrate is located at the side of the orthographic projection of the first gate line on the base substrate away from the orthographic projection of the first conductive portion on the base substrate. The orthographic projection of the second gate line on the base substrate is located between the orthographic projection of the first reset signal line on the base substrate and the orthographic projection of the first gate line on the base substrate.

In an exemplary embodiment of the present disclosure, the first direction is a row direction, and the display panel includes a plurality of rows of pixel driving circuits. The orthographic projection on the base substrate of the second initial signal line in the pixel driving circuit of a previous adjacent row is located between the orthographic projection on the base substrate of the first reset signal line in the pixel driving circuit of the current row and the orthographic projection on the base substrate of the second gate line in the pixel driving circuit of the current row. The orthographic projection on the base substrate of the first initial signal line in the pixel driving circuit of a next adjacent row is located between the orthographic projection on the base substrate of the second reset signal line in the pixel driving circuit of the current row and the orthographic projection on the base substrate of the enable signal line in the pixel driving circuit of the current row. The second reset signal line in the pixel driving circuit of the current row is reused as the first reset signal line in the pixel driving circuit of the next adjacent row.

In an exemplary embodiment of the present disclosure, the first transistor, the second transistor, the driving transistor, the fourth transistor, the fifth transistor, the sixth transistor, and the seventh transistor are P-type transistors, and the eighth transistor is an N-type transistor.

According to an aspect of the present disclosure, a display device is provided, which includes the above-mentioned display panel.

It should be understood that the above general description and the detailed description below are only exemplary and explanatory, and cannot limit the present disclosure.

### BRIEF DESCRIPTION OF THE DRAWINGS

The drawings herein are incorporated into the specification and constitute a part of the specification, showing embodiments consistent with the present disclosure, and together with the specification, are used to explain the principles of the present disclosure. It is noted that the drawings described below are only some embodiments of the present disclosure. For those of ordinary skills in the art, other drawings can be obtained based on these drawings without creative work.
Fig. 1 is a schematic diagram of a circuit structure of a pixel driving circuit in a display panel according to an exemplary embodiment of the present disclosure;
Fig. 2 is a timing diagram of the signals at each node in the pixel driving circuit shown in Fig. 1;
Fig. 3 is a structural layout of a display panel according to an exemplary embodiment of the present disclosure;
Fig. 4 is a structural layout of the shielding layer in Fig. 3;
Fig. 5 is a structural layout of the first active layer in Fig. 3;
Fig. 6 is a structural layout of the first conductive layer in Fig. 3;
Fig. 7 is a structural layout of the second conductive layer in Fig. 3;
Fig. 8 is a structural layout of the second active layer in Fig. 3;
Fig. 9 is a structural layout of the third conductive layer in Fig. 3;
Fig. 10 is a structural layout of the fourth conductive layer in Fig. 3;
Fig. 11 is a structural layout of the fifth conductive layer in Fig. 3;
Fig. 12 is a structural layout of the electrode layer in Fig. 3;
Fig. 13 is a structural layout of the shielding layer and the first active layer in Fig. 3;
Fig. 14 is a structural layout of the shielding layer, the first active layer, and the first conductive layer in Fig. 3;
Fig. 15 is a structural layout of the shielding layer, the first active layer, the first conductive layer, and the second conductive layer in Fig. 3;
Fig. 16 is a structural layout of the shielding layer, the first active layer, the first conductive layer, the second conductive layer, and the second active layer in Fig. 3;
Fig. 17 is a structural layout of the shielding layer, the first active layer, the first conductive layer, the second conductive layer, the second active layer, and the third conductive layer in Fig. 3;
Fig. 18 is a structural layout of the shielding layer, the first active layer, the first conductive layer, the second conductive layer, the second active layer, the third conductive layer, and the fourth conductive layer in Fig. 3;
Fig. 19 is a structural layout of the shielding layer, the first active layer, the first conductive layer, the second conductive layer, the second active layer, the third conductive layer, the fourth conductive layer, and the fifth conductive layer in Fig. 3;
Fig. 20 is a structural layout of the fifth conductive layer and the electrode layer in a display panel according to an exemplary embodiment of the present disclosure;
Fig. 21 is a structural layout of the fifth conductive layer in Fig. 20;
Fig. 22 is a structural layout of the electrode layer in Fig. 20;
Fig. 23 is a partial cross-sectional view along the dotted line AA of the display panel shown in Fig. 3.

### DETAILED DESCRIPTION OF THE EMBODIMENTS

The example embodiments will now be described more fully with reference to the accompanying drawings. However, the example embodiments may be implemented in a variety of forms, and should not be construed as being limited to the examples set forth herein. Rather, these embodiments are provided so that the present disclosure will be more comprehensive and complete, and the concepts of the example embodiments will be fully conveyed to those skilled in the art. The same reference numerals in the figures represent the same or similar structures, and their detailed descriptions will be omitted.

The terms "one", "an", and "said" are used to indicate the presence of one or more elements or components, etc. The terms "including" and "having" are used to indicate an open-ended inclusion, and mean that there may be additional elements or components, etc. in addition to the listed elements or components, etc.

In the related art, a display panel includes a plurality of sub-pixel units, each sub-pixel unit may include a pixel driving circuit and a light-emitting unit, and the pixel driving circuit provides a driving current to the light-emitting unit according to a data signal so that the light-emitting unit is driven to emit light. Since light-emitting units of different colors have light-emitting layers of different materials, the data signal voltages required for sub-pixel units of different colors in the black state are different. That is, with the same driving current, light-emitting units of different colors have different brightness. For example, the data signal voltage required for the blue sub-pixel unit in the black state is less than the data signal voltage required for the red and green sub-pixel units in the black state. Taking the driving transistor in the pixel driving circuit being a P-type transistor as an example, the greater the data signal voltage, the lower the brightness of the light-emitting unit. With the same driving current, the brightness of the blue light-emitting unit is less than the brightness of the red light-emitting unit and the brightness of the green light-emitting unit. At the same time, since the data signals of the sub-pixel units of different colors in the display panel are the same in the black state, the display panel displays abnormally, especially at low grayscale. For example, the data signal voltage required for the blue sub-pixel unit in the black state is 6V, the data signal voltages required for the red sub-pixel unit and the green sub-pixel in the black state are 6.5V, and the data signal voltage when the display panel displays a black screen is 6.5V. Obviously, when the data signal voltage is less than 6.5V, the brightness of the blue light-emitting unit is less than the brightness of the red light-emitting unit and the brightness of the green light-emitting unit.

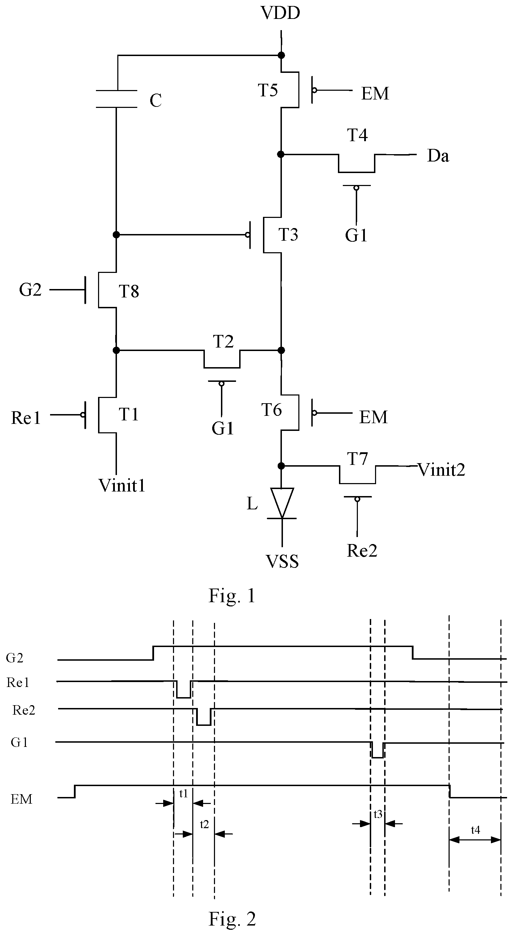

In view of above, an exemplary embodiment of the present disclosure provides a display panel, as shown in Fig. 1, which is a schematic diagram of a circuit structure of a pixel driving circuit in a display panel according to an exemplary embodiment of the present invention. The pixel driving circuit may include a first transistor T1, a second transistor T2, a driving transistor T3, a fourth transistor T4, a fifth transistor T5, a sixth transistor T6, a seventh transistor T7, an eighth transistor T8, and a capacitor C. The eighth transistor T8 has the first terminal connected to the gate of the driving transistor T3, and the gate connected to the second gate driving signal terminal G2. The first transistor T1 has the first terminal connected to the first initial signal terminal Vinit1, the second terminal connected to the second terminal of the eighth transistor T8, and the gate connected to the first reset signal terminal Re1. The second transistor T2 has the first terminal connected to the second terminal of the eighth transistor T8, the second terminal connected to the second terminal of the driving transistor T3, and the gate connected to the first gate driving signal terminal G1. The fourth transistor T4 has the first terminal connected to the data signal terminal Da, the second terminal connected to the first terminal of the driving transistor T3, and the gate connected to the first gate driving signal terminal G1. The fifth transistor T5 has the first terminal connected to the first power terminal VDD, the second terminal connected to the first terminal of the driving transistor T3, and the gate connected to the enable signal terminal EM. The sixth transistor T6 has the first terminal connected to the second terminal of the driving transistor T3, and the gate connected to the enable signal terminal EM. The seventh transistor T7 has the first terminal connected to the second initial signal terminal Vinit2, the second terminal connected to the second terminal of the sixth transistor T6, and the gate connected to the second reset signal terminal Re2. The first electrode of the capacitor is connected to the gate of the driving transistor T3, and the second electrode of the capacitor is connected to the first power terminal VDD. The pixel driving circuit may be used to drive the light-emitting unit L to emit light. The first electrode of the light-emitting unit L is connected to the second terminal of the sixth transistor T6, and the second electrode of the light-emitting unit L is connected to the second power terminal VSS. The first transistor T1, the second transistor T2, the driving transistor T3, the fourth transistor T4, the fifth transistor T5, the sixth transistor T6, and the seventh transistor T7 may all be P-type transistors, and the eighth transistor T8 may be an N-type transistor.

As shown in Fig. 2, it is a timing diagram of the signals at each node in the pixel driving circuit shown in Fig. 1. EM represents the timing diagram of the signal at the enable signal terminal. G1 represents the timing diagram of the signal at the first gate driving signal terminal. G2 represents the timing diagram of the signal at the second gate driving signal terminal. Re1 represents the timing diagram of the signal at the first reset signal terminal. Re2 represents the timing diagram of the signal at the second reset signal terminal.

The driving method of the pixel driving circuit in the present disclosure may include a first reset stage t1, a second reset stage t2, a data writing stage t3, and a light-emitting stage t4. In the first reset stage t1, the first reset signal terminal Re1 outputs a low level, the second gate driving signal terminal G2 outputs a high level, the first transistor T1 and the eighth transistor T8 are turned on, and the first initial signal terminal Vinit1 inputs a first initial signal to the gate of the driving transistor T3. In the second reset stage t2, the second reset signal terminal Re2 outputs a low level signal, the seventh transistor T7 is turned on, and the second initial signal terminal Vinit2 inputs a second initial signal to the first electrode of the light-emitting unit. In the data writing stage t3, the first gate driving signal terminal G1 outputs a low level signal, the second gate driving signal terminal G2 outputs a high level signal, the eighth transistor T8, the fourth transistor T4, and the second transistor T2 are turned on, and the data signal terminal Da outputs a data signal so that a compensation voltage Vdata+Vth is written to the gate of the driving transistor, where Vdata is the voltage of the data signal and Vth is the threshold voltage of the driving transistor T3. In the light-emitting stage t4, the enable signal terminal EM outputs a low level signal, the fifth transistor T5 and the sixth transistor T6 are turned on, and the driving transistor T3 drives the light-emitting unit L to emit light by the voltage Vdata+Vth at the gate of the driving transistor T3. The output current formula of the driving transistor is I=( µ WCox/2L)(Vgs-Vth)², where µ is the carrier mobility, Cox is the gate capacitance per unit area, W is the channel width of the driving transistor, L is the channel length of the driving transistor, Vgs is the gate-source voltage difference of the driving transistor, and Vth is the threshold voltage of the driving transistor. The output current of the driving transistor in the pixel driving circuit of the present disclosure is I=( µ WCox/2L)(Vdata+Vth-Vdd-Vth)². The pixel driving circuit helps to avoid the influence of the threshold of the driving transistor on its output current.

In an exemplary embodiment, the display panel may include a plurality of the above-mentioned pixel driving circuits. The plurality of pixel driving circuits includes a first pixel driving circuit and a second pixel driving circuit. The display panel also includes a plurality of light-emitting units. The plurality of light-emitting units includes a first light-emitting unit and a second light-emitting unit. The first pixel driving circuit is used to drive the first light-emitting unit, and the second pixel driving circuit is used to drive the second light-emitting unit. The capacitance formed by the first gate line and the equipotential structure of the gate of the driving transistor in the first pixel driving circuit is C1. The capacitance formed by the first gate line and the equipotential structure of the gate of the driving transistor in the second pixel driving circuit is C2. The first gate line may be used to provide the first gate driving signal terminal G1 in Fig. 1. With the same driving current, the brightness of the first light-emitting unit is less than the brightness of the second light-emitting unit, and C1 is less than C2.

In an exemplary embodiment, the first gate line changes from a low level to a high level at the end of the data writing phase t3. The first gate line may pull up the voltage of the gate of the driving transistor through the coupling effect of the capacitance between the first gate line and the gate of the driving transistor. In an exemplary embodiment, the capacitance formed by the first gate line and the equipotential structure of the gate of the driving transistor in the first pixel driving circuit is smaller than the capacitance formed by the first gate line and the equipotential structure of the gate of the driving transistor in the second pixel driving circuit. Thus, the pull-up effect of the first gate line on the gate of the driving transistor in the first pixel driving circuit is smaller than the pull-up effect of the first gate line on the gate of the driving transistor in the second pixel driving circuit. That is, with the same data signal, the actual driving voltage of the gate of the driving transistor in the first pixel driving circuit is smaller than the actual driving voltage of the gate of the driving transistor in the second pixel driving circuit. The difference in the actual driving voltage may perfectly compensate for the difference in the data signal voltage required by the first light-emitting unit and the second light-emitting unit in the black state. Thus, according to this exemplary embodiment, the brightness of the first light-emitting unit and the brightness of the second light-emitting unit can be the same under the same data signal.

It should be noted that in other exemplary embodiments, the pixel driving circuit may also be other structures. As long as the pixel driving circuit includes the driving transistor T3 and the fourth transistor T4, the display abnormality caused by the difference in the data signal voltage required by different light-emitting units in the black state can be compensated by the differentiated setting of the capacitance between the first gate line and the equipotential structure of the gate of the driving transistor in different pixel driving circuits. In addition, the differentiated setting of the capacitance between the first gate line and the equipotential structure of the gate of the driving transistor in different pixel driving circuits may also be used to solve problems like inconsistent brightness of different light-emitting units under the same data signal voltage caused by other reasons. For example, the setting may also solve problems like inconsistent brightness of different light-emitting units under the same data signal voltage caused by differences in output characteristics of the driving transistor in the pixel driving circuit.

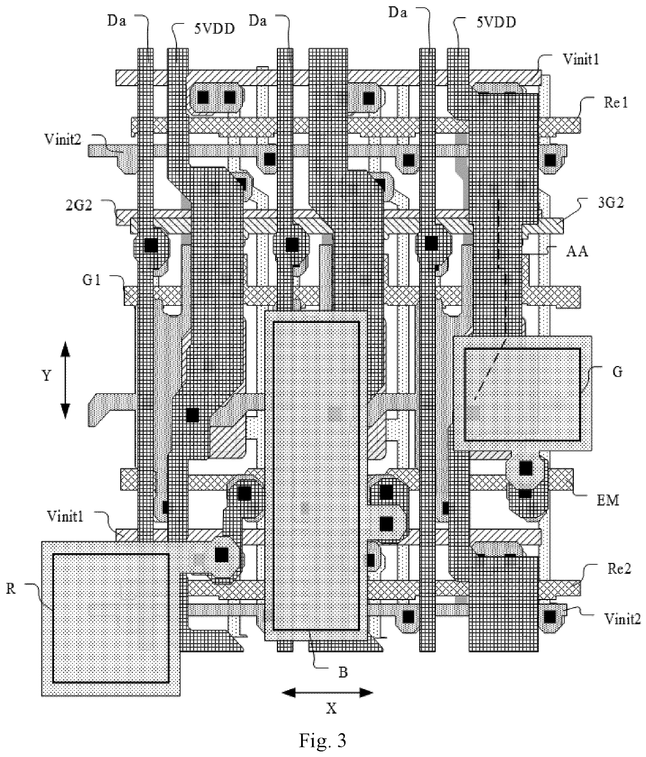

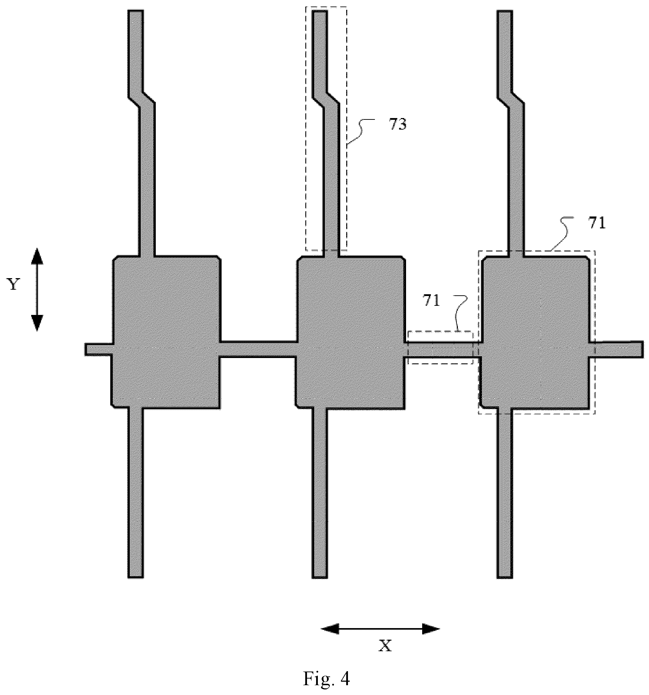

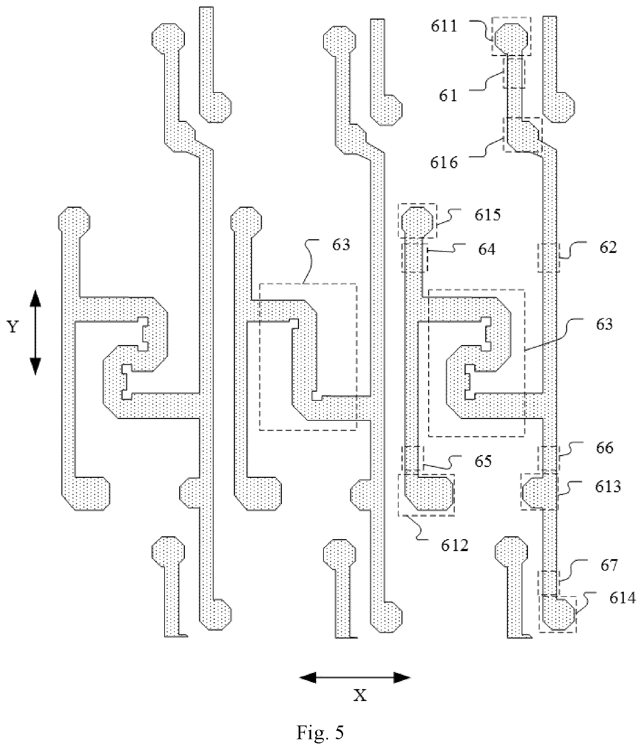

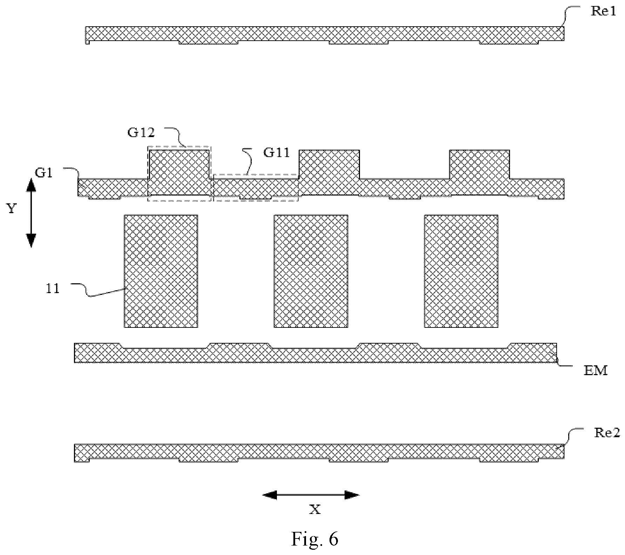

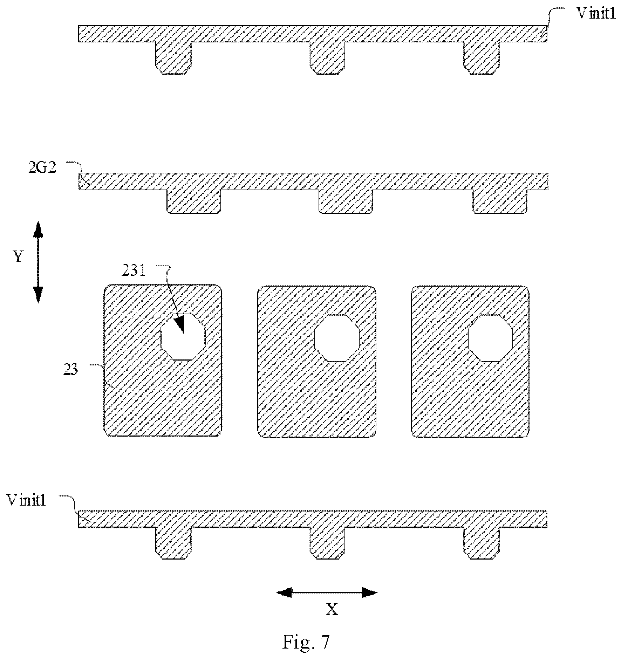

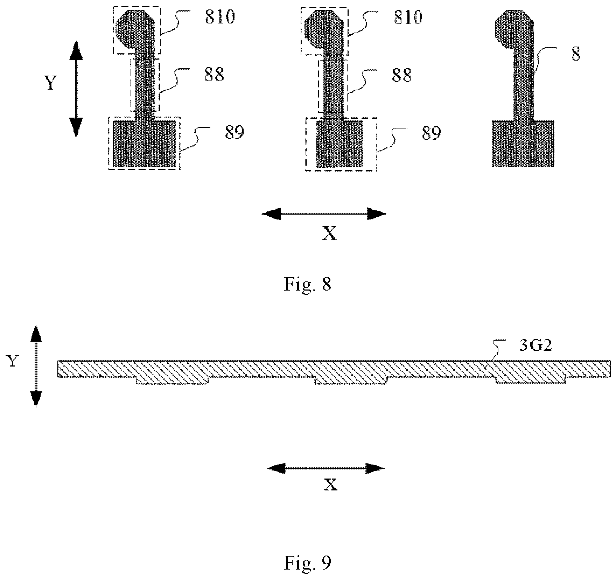

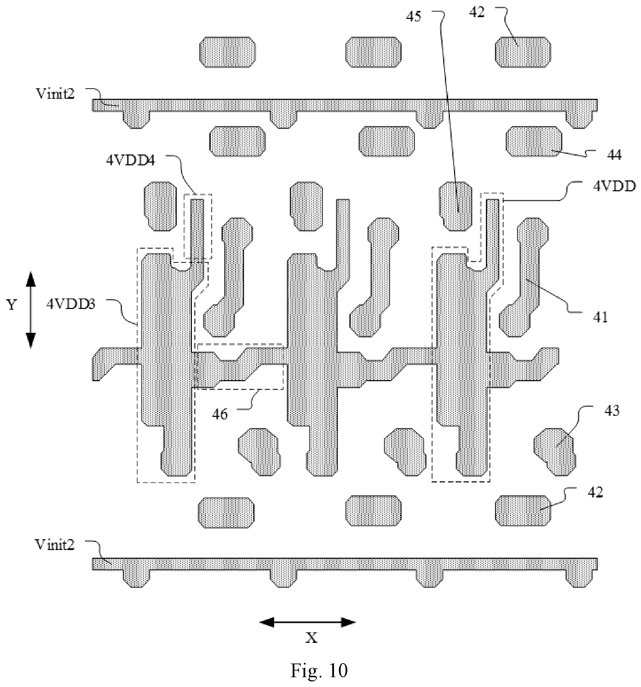

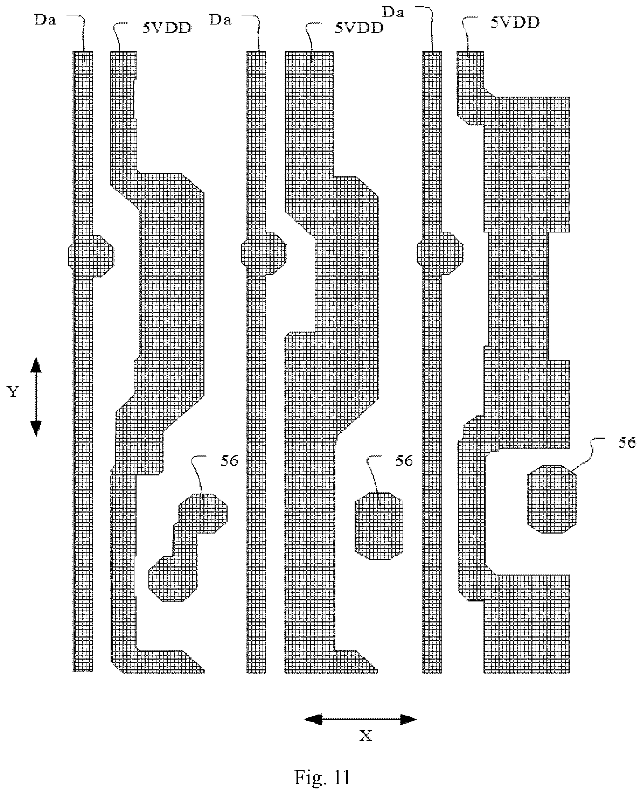

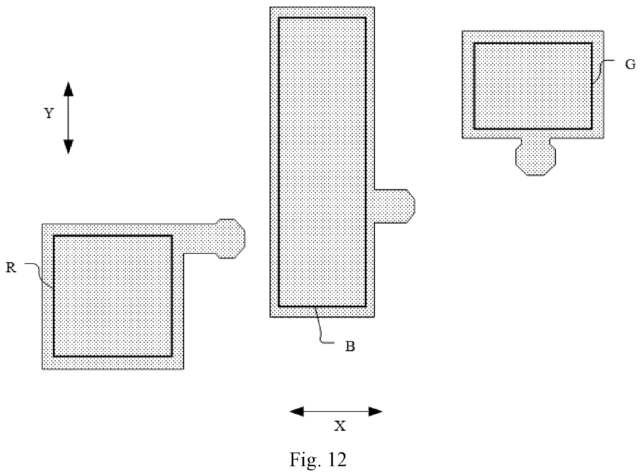

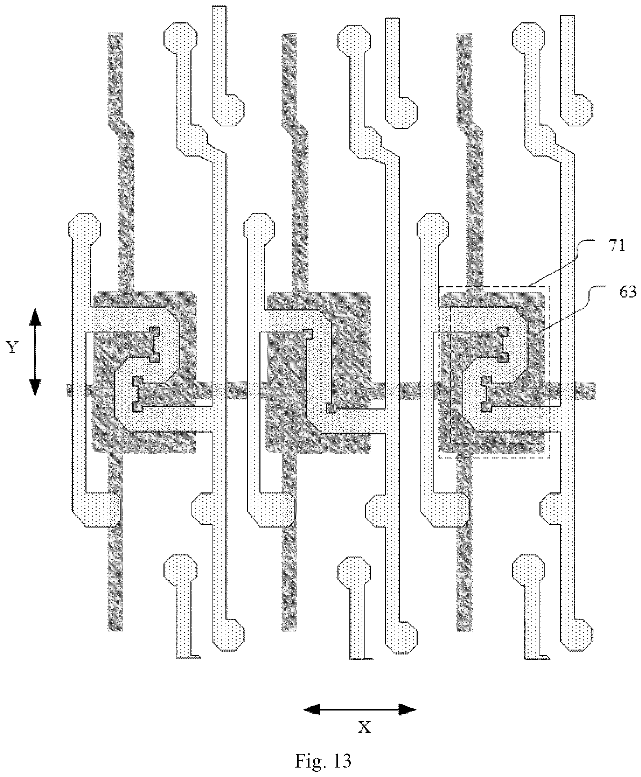

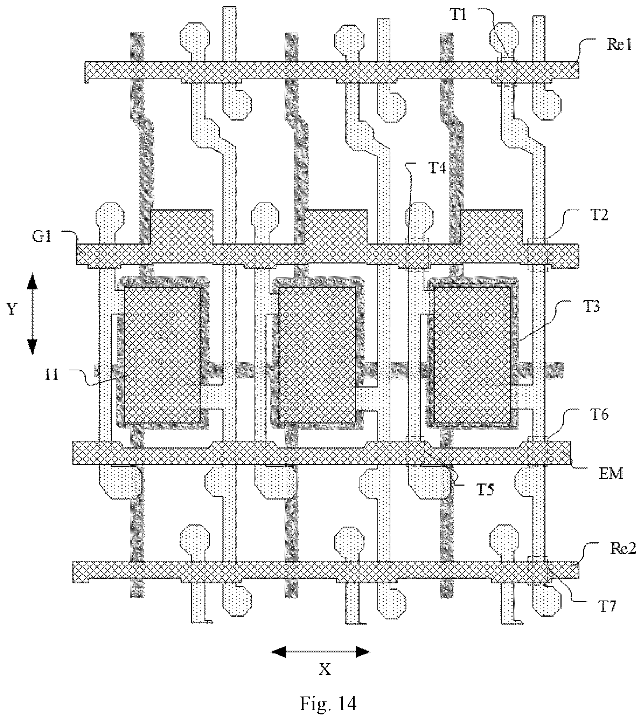

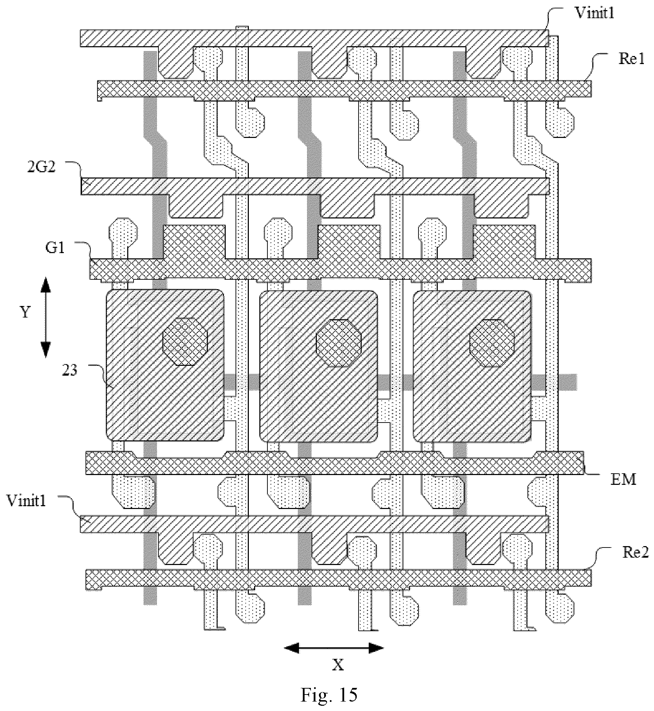

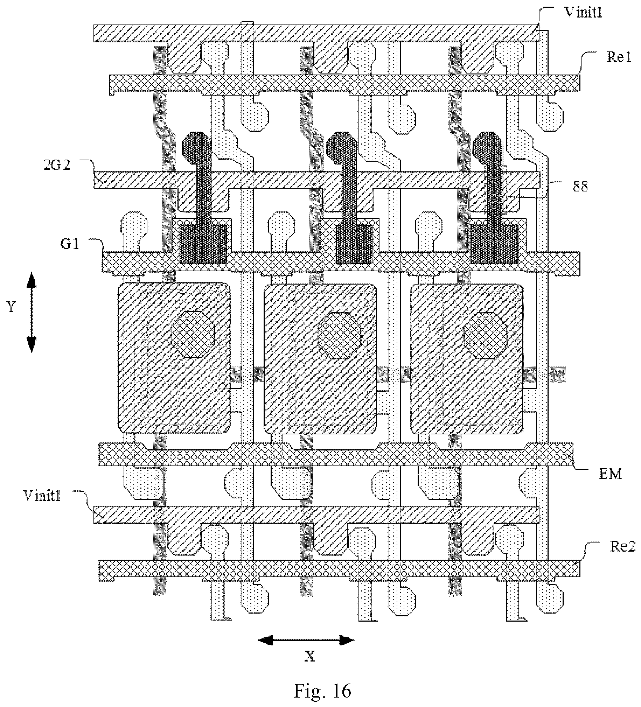

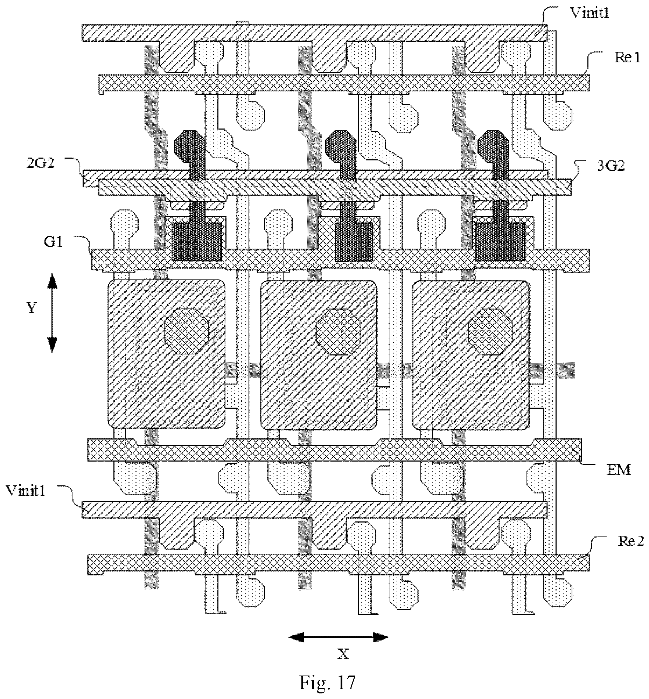

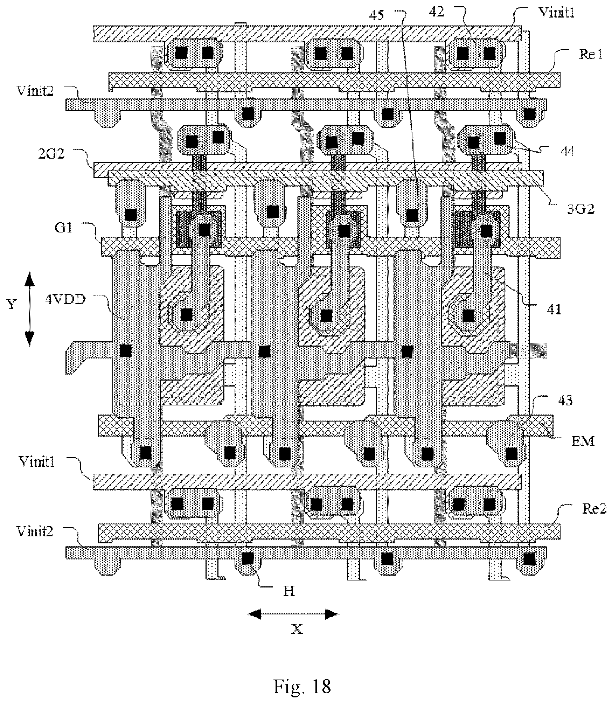

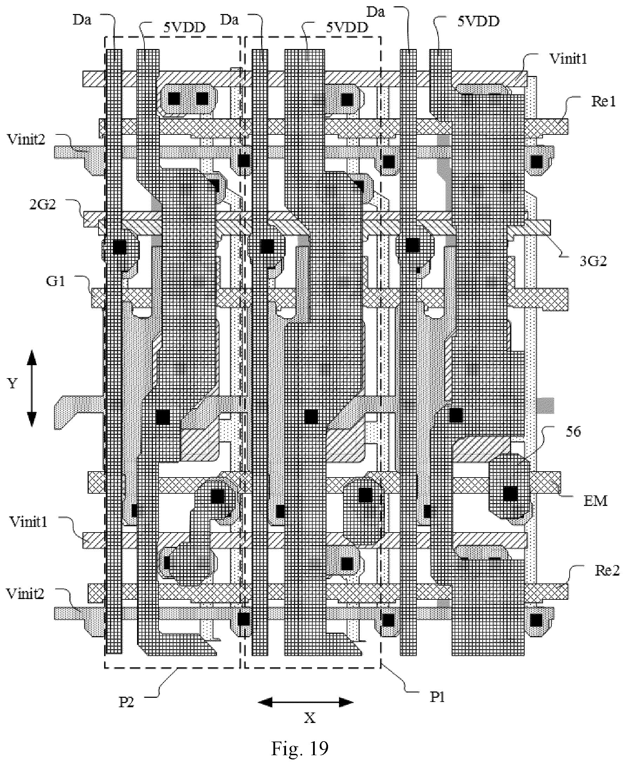

In an exemplary embodiment, the display panel may include a base substrate, a shielding layer, a first active layer, a first conductive layer, a second conductive layer, a second active layer, a third conductive layer, a fourth conductive layer, a fifth conductive layer, and an electrode layer, which are stacked in sequence. An insulation layer may be provided between adjacent layers. As shown in Figs. 3-19, Fig. 3 is a structural layout of a display panel according to an exemplary embodiment of the present disclosure, Fig. 4 is a structural layout of the shielding layer in Fig. 3, Fig. 5 is a structural layout of the first active layer in Fig. 3, Fig. 6 is a structural layout of the first conductive layer in Fig. 3, Fig. 7 is a structural layout of the second conductive layer in Fig. 3, Fig. 8 is a structural layout of the second active layer in Fig. 3, Fig. 9 is a structural layout of the third conductive layer in Fig. 3, Fig. 10 is a structural layout of the fourth conductive layer in Fig. 3, Fig. 11 is a structural layout of the fifth conductive layer in Fig. 3, Fig. 12 is a structural layout of the electrode layer in Fig. 3, Fig. 13 is a structural layout of the shielding layer and the first active layer in Fig. 3, Fig. 14 is a structural layout of the shielding layer, the first active layer, and the first conductive layer in Fig. 3, Fig. 15 is a structural layout of the shielding layer, the first active layer, the first conductive layer, and the second conductive layer in Fig. 3, Fig. 16 is a structural layout of the shielding layer, the first active layer, the first conductive layer, the second conductive layer, and the second active layer in Fig. 3, Fig. 17 is a structural layout of the shielding layer, the first active layer, the first conductive layer, the second conductive layer, the second active layer, and the third conductive layer in Fig. 3, Fig. 18 is a structural layout of the shielding layer, the first active layer, the first conductive layer, the second conductive layer, the second active layer, the third conductive layer, and the fourth conductive layer in Fig. 3, and Fig. 19 is a structural layout of the shielding layer, the first active layer, the first conductive layer, the second conductive layer, the second active layer, the third conductive layer, the fourth conductive layer, and the fifth conductive layer in Fig. 3. The display panel may include a plurality of pixel driving circuits shown in Fig. 1. As shown in Fig. 19, the plurality of pixel driving circuits may include the first pixel driving circuit P1 and the second pixel driving circuit P2 described above.

As shown in Fig. 3, Fig. 4, and Fig. 13, the shielding layer may include a plurality of shielding portions 71, connecting portions 73, and connecting portions 72. The orthographic projection of the connecting portion 73 on the base substrate extends along the second direction Y, and is connected between adjacent shielding portions 71 in the second direction Y. The orthographic projection of the connecting portion 72 on the base substrate extends along the first direction X, and is connected between adjacent shielding portions 71 in the first direction X. The first direction X and the second direction Y may be connected to each other. For example, the first direction X may be a row direction and the second direction Y may be a column direction.

As shown in Fig. 3, Fig. 5, Fig. 13, and Fig. 14, the first active layer may include a first active portion 61, a second active portion 62, a third active portion 63, a fourth active portion 64, a fifth active portion 65, a sixth active portion 66, and a seventh active portion 67. The first active portion 61 is used to form the channel region of the first transistor T1. The second active portion 62 is used to form the channel region of the second transistor T2. The third active portion 63 is used to form the channel region of the driving transistor T3. The fourth active portion 64 is used to form the channel region of the fourth transistor T4. The fifth active portion 65 is used to form the channel region of the fifth transistor T5. The sixth active portion 66 is used to form the channel region of the sixth transistor T6. The seventh active portion 67 is used to form the channel region of the seventh transistor T7. In addition, the first active layer may further include an eleventh active portion 611, a twelfth active portion 612, a thirteenth active portion 613, a fourteenth active portion 614, a fifteenth active portion 615, and a sixteenth active portion 616. The fifteenth active portion 615 is connected to the end of the fourth active portion 64 away from the third active portion 63. The sixteenth active portion 616 is connected between the first active portion 61 and the second active portion 62. The eleventh active portion 611 is connected to the end of the first active portion 61 away from the second active portion 62. The twelfth active portion 612 is connected to the end of the fifth active portion 65 away from the third active portion 63. The thirteenth active portion 613 is connected between the sixth active portion 66 and the seventh active portion 67. The fourteenth active portion 614 is connected to the end of the seventh active portion 67 away from the sixth active portion 66. The orthographic projection of the shielding portion 71 on the base substrate may cover the orthographic projection of the third active portion 63 on the base substrate. The shielding portion 71 can shield the third active portion 63 from light, so as to reduce the influence of light on the driving characteristics of the driving transistor T3. In addition, the shielding layer may be a conductive material, and the shielding layer may also be connected to a stable voltage source to shield the driving transistor T3 from noise. For example, the shielding layer may be connected to the first power terminal VDD, the first initial signal terminal Vinit1, the second initial signal terminal Vinit2, the second power terminal VSS, etc. The first active layer may be formed of polysilicon material. Accordingly, the first transistor T1, the second transistor T2, the driving transistor T3, the fourth transistor T4, the fifth transistor T5, the sixth transistor T6, and the seventh transistor T7 may be P-type low-temperature polysilicon thin film transistors.

As shown in Figs. 3, 6, and 14, the first conductive layer may include a first reset signal line Re1, a first gate line G1, an enable signal line EM, a second reset signal line Re2, and a first conductive portion 11. The first reset signal line Re1 may be used to provide the first reset signal terminal in Fig. 1. The orthographic projection of the first reset signal line Re1 on the base substrate may cover the orthographic projection of the first active portion 61 on the base substrate. A partial structure of the first reset signal line Re1 may be used to form the gate of the first transistor T1. The first gate line G1 may be used to provide the first gate driving signal terminal in Fig. 1. The orthographic projection of the first gate line G1 on the base substrate may cover the orthographic projection of the second active portion 62 on the base substrate and the orthographic projection of the fourth active portion 64 on the base substrate. A partial structure of the first gate line G1 may be used to form the gate of the second transistor T2, and another partial structure of the first gate line G1 may be used to form the gate of the fourth transistor T4. The enable signal line EM is used to provide the enable signal terminal in Fig. 1. The orthographic projection of the enable signal line EM on the base substrate may extend along the first direction X, and cover the orthographic projection of the fifth active portion 65 on the base substrate and the orthographic projection of the sixth active portion 66 on the base substrate. A partial structure of the enable signal line EM may be used to form the gate of the fifth transistor T5, and another partial structure of the enable signal line EM may be used to form the gate of the sixth transistor T6. The second reset signal line Re2 is used to provide the second reset signal terminal in Fig. 1. The orthographic projection of the second reset signal line Re2 on the base substrate may cover the orthographic projection of the seventh active portion 67 on the base substrate. A partial structure of the second reset signal line Re2 may be used to form the gate of the seventh transistor T7. The orthographic projection of the first conductive portion 11 on the base substrate may cover the orthographic projection of the third active portion 63 on the base substrate. The first conductive portion 11 may be used to form the gate of the driving transistor T3 and the first electrode of the capacitor C.

As shown in Figs. 3, 6, and 14, the orthographic projection of the first reset signal line Re1 on the base substrate, the orthographic projection of the first gate line G1 on the base substrate, the orthographic projection of the first conductive portion 11 on the base substrate, the orthographic projection of the enable signal line EM on the base substrate, and the orthographic projection of the second reset signal line Re2 on the base substrate may be arranged in sequence along the second direction Y. The first reset signal line Re1 in the pixel driving circuit of a row may be reused as the second reset signal line Re2 in the pixel driving circuit of the previous adjacent row. This setting can improve the integration of the pixel driving circuits in the second direction Y. In addition, the display panel may use the first conductive layer as a mask to perform conductor processing on the first active layer. That is, the area covered by the first conductive layer in the first active layer may form the channel region of the transistor, and the area not covered by the first conductive layer in the first active layer forms a conductor structure.

As shown in Figs. 3, 7, and 15, the second conductive layer may include a third gate line 2G2, a first initial signal line Vinit1, and a third conductive portion 23. The orthographic projection of the first initial signal line Vinit1 on the base substrate and the orthographic projection of the third gate line 2G2 on the base substrate may both extend along the first direction X. The first initial signal line Vinit1 is used to provide the first initial signal terminal in Fig. 1, and the third gate line 2G2 is used to provide the second gate driving signal terminal in Fig. 1. The orthographic projection of the third conductive portion 23 on the base substrate may overlap with the orthographic projection of the first conductive portion 11 on the base substrate. The third conductive portion 23 may be used to form the second electrode of the capacitor C. As shown in Figs. 3, 7, and 15, the orthographic projection on the base substrate of the first initial signal line Vinit1 in the pixel driving circuit of the next adjacent row may be located between the orthographic projection on the base substrate of the enable signal line EM in the pixel driving circuit of the current row and the orthographic projection on the base substrate of the second reset signal line Re2 in the pixel driving circuit of the current row. This setting can further improve the integration of the pixel driving circuits in the second direction Y. It should be understood that in other exemplary embodiments, the first initial signal line Vinit1 may also be located on other conductive layers. For example, the first initial signal line Vinit1 may also be located on the shielding layer, the third conductive layer, the fourth conductive layer, etc.

As shown in Figs. 3, 8, and 16, the second active layer may include a plurality of active portions 8. The active portion 8 includes an eighth active portion 88, a ninth active portion 89, and a tenth active portion 810. The eighth active portion 88 is connected between the ninth active portion 89 and the tenth active portion 810. The eighth active portion 88 is used to form the channel region of the eighth transistor. The orthographic projection of the third gate line 2G2 on the base substrate may cover the orthographic projection of the eighth active portion 88 on the base substrate. A partial structure of the third gate line 2G2 may be used to form the bottom gate of the eighth transistor T8. The second active layer may be formed of indium gallium zinc oxide. Accordingly, the eighth transistor T8 may be an N-type metal oxide thin film transistor.

As shown in Figs. 3, 9, and 17, the third conductive layer may include a second gate line 3G2, and the orthographic projection of the second gate line 3G2 on the base substrate may extend along the first direction X. The second gate line 3G2 is used to provide the second gate driving signal terminal in Fig. 1. The orthographic projection of the second gate line 3G2 on the base substrate may cover the orthographic projection of the eighth active portion 88 on the base substrate. A partial structure of the second gate line 3G2 may be used to form the top gate of the eighth transistor T8. The second gate lines 3G2 and the third gate lines 2G2 in the same row of pixel driving circuits may be connected through via holes. The via hole connected between the second gate line 3G2 and the third gate line 2G2 may be located in the edge wiring area outside the display area of the display panel. In addition, the display panel may use the third conductive layer as a mask to perform conductor processing on the second active layer. That is, the area covered by the third conductive layer in the second active layer may form the channel region of the transistor, and the area not covered by the third conductive layer in the second active layer forms a conductor structure.

As shown in Figs. 3, 9, and 17, in the same pixel driving circuit, and along the first direction X, the orthographic projection of the second active portion 62 on the base substrate is located at the side of the orthographic projection of the eighth active portion 88 on the base substrate away from the orthographic projection of the connecting portion 73 on the base substrate. This setting can enable the second active portion 62 away from the connecting portion 73, thereby avoiding the change in the crystallization state of the first active layer and the risk of tunneling caused by the edge morphology of the connecting portion 73.

As shown in Figs. 3, 9, and 17, the minimum distance between the orthographic projection of the first active portion 61 on the base substrate and the orthographic projection of the shielding layer on the base substrate is L3, and the size in the first direction X of the orthographic projection of the first active portion 61 on the base substrate is L4, where L3 may be greater than or equal to L4. For example, L3 may be 1 times, 2 times, 3 times, 4 times, etc. of L4. The minimum distance between the orthographic projection of the second active portion 62 on the base substrate and the orthographic projection of the shielding layer on the base substrate is L7, and the size in the first direction X of the orthographic projection of the second active portion 62 on the base substrate is L8, where L7 may be greater than or equal to L8. For example, L7 may be 0.5 times, 1 times, 2 times, 3 times, 4 times, etc. of L8. The minimum distance between the orthographic projection of the fourth active portion 64 on the base substrate and the orthographic projection of the shielding layer on the base substrate is L9, and the size in the first direction X of the orthographic projection of the fourth active portion 64 on the base substrate is L10, where L9 may be greater than or equal to L10. For example, L9 may be 1 times, 2 times, 3 times, 4 times, etc. of L10. The minimum distance between the orthographic projection of the fifth active portion 65 on the base substrate and the orthographic projection of the shielding layer on the base substrate is L11, and the size in the first direction X of the orthographic projection of the fifth active portion 65 on the base substrate is L12, where L11 may be greater than or equal to L12. For example, L11 may be 1 times, 2 times, 3 times, 4 times, etc. of L12. The minimum distance between the orthographic projection of the sixth active portion 66 on the base substrate and the orthographic projection of the shielding layer on the base substrate is L13, and the size in the first direction X of the orthographic projection of the sixth active portion 66 on the base substrate is L14, where L13 may be greater than or equal to L14. For example, L13 may be 1 times, 2 times, 3 times, 4 times, etc. of L14. The minimum distance between the orthographic projection of the seventh active portion 67 on the base substrate and the orthographic projection of the shielding layer on the base substrate is L15, and the size in the first direction X of the orthographic projection of the seventh active portion 67 on the base substrate is L16, where L15 may be greater than or equal to L16. For example, L15 may be 1 times, 2 times, 3 times, 4 times, etc. of L16. This setting enables the shielding layer away from the channel region in the first active layer, so as to avoid the change of the crystallization state of the first active layer and the risk of tunneling caused by the edge morphology of the shielding layer. It should be understood that in other exemplary embodiments, the distance between the orthographic projection on the base substrate of the shielding layer and the orthographic projection on the base substrate of the channel region in the first active layer may not be limited.

As shown in Figs. 3, 10, and 18, the fourth conductive layer may include a second initial signal line Vinit2, a first power line segment 4VDD, a first bridge portion 41, a second bridge portion 42, a third bridge portion 43, a fourth bridge portion 44, and a fifth bridge portion 45. The second initial signal line Vinit2 may be used to provide the second initial signal terminal in Fig. 1. The second initial signal line Vinit2 may be connected to the fourteenth active portion 614 through a via hole H, so as to connect the first terminal of the seventh transistor T7 and the second initial signal terminal, where the black square indicates the position of the via hole. The first power line segment 4VDD is arranged in one-to-one correspondence with the pixel driving circuit. The orthographic projections of the plurality of first power line segments 4VDD on the base substrate are arranged in an array along the first direction X and the second direction Y, and extend along the second direction Y. The first power line segment 4VDD may be connected to the twelfth active portion 612 and the third conductive portion 23 through via holes, respectively, so as to connect the first terminal of the fifth transistor T5 and the second electrode of the capacitor C. The first bridge portion 41 may be connected to the first conductive portion 11 and the ninth active portion 89 through via holes, respectively, so as to connect the gate of the driving transistor T3 and the first terminal of the eighth transistor T8. As shown in Fig. 7, an opening 231 is formed on the third conductive portion 23. The orthographic projection on the base substrate of the via hole connected between the first conductive portion 11 and the first bridge portion 41 is located within the orthographic projection of the opening 231 on the base substrate, so that the via hole connected between the first conductive portion 11 and the first bridge portion 41 is insulated from the third conductive portion 23. The second bridge portion 42 may be connected to the eleventh active portion 611 and the first initial signal line Vinit1 through via holes, respectively, so as to connect the first terminal of the first transistor T1 and the first initial signal terminal. The third bridge portion 43 may be connected to the thirteenth active portion 613 through a via hole, so as to connect the second terminal of the sixth transistor T6 and the second terminal of the seventh transistor T7. The fourth bridge portion 44 may be connected to the tenth active portion 810 and the sixteenth active portion 616 through via holes respectively, so as to connect the second terminal of the eighth transistor T8 with the second terminal of the first transistor and the first terminal of the second transistor. The fifth bridge portion 45 is connected to the fifteenth active portion 615 through a via hole, so as to connect the first terminal of the fourth transistor. In an exemplary embodiment, the orthographic projection on the base substrate of the second initial signal line Vinit2 in the pixel driving circuit of the previous adjacent row is located between the orthographic projection on the base substrate of the first reset signal line Re1 in the pixel driving circuit of the current row and the orthographic projection on the base substrate of the second gate line 3G2 in the pixel driving circuit of the current row. This setting can improve the integration of the pixel driving circuits in the second direction Y. It should be understood that the second initial signal line Vinit2 may also be located on other conductive layers. For example, the second initial signal line Vinit2 may be located on the shielding layer, the second conductive layer, the third conductive layer, and the like.

As shown in Figs. 3, 8, 17, and 18, in an exemplary embodiment, the first gate line G1 is arranged between the first conductive portion 11 and the second gate line 3G2, so that the coupling effect between the first gate line G1 and the first conductive portion 11 can be increased. At the end of the data writing stage, the voltage of the first gate line G1 increases, and the first gate line G1 can pull up the voltage of the gate of the driving transistor T3. This setting can reduce the voltage of the data signal on the black screen of the display panel, thereby reducing the power consumption of the display panel. In an exemplary embodiment, the orthographic projection of the ninth active portion 89 on the base substrate and the orthographic projection of the first gate line G1 on the base substrate at least partially overlap. At the end of the data writing stage, the first gate line G1 can pull up the voltage of the gate of the driving transistor T3 through the ninth active portion 89. This setting can further reduce the voltage of the data signal on the black screen of the display panel, thereby reducing the power consumption of the display panel.

As shown in Figs. 3, 6, 8, 17, and 18, the first gate line G1 may include a plurality of first extension portions G11 and a plurality of second extension portions G12. The orthographic projections of the plurality of first extension portions G11 on the base substrate extend along the first direction X, and are spaced apart along the first direction X. The second extension portion G12 is connected between adjacent first extension portions in the first direction X. The size in the second direction Y of the orthographic projection of the first extension portion G11 on the base substrate is smaller than the size in the second direction Y of the orthographic projection of the second extension portion G12 on the base substrate. The ninth active portion 89 is an equipotential structure of the gate of the driving transistor. In an exemplary embodiment, the differentiated setting of C1 and C2 is achieved by adjusting the overlap area between the ninth active portion 89 and the second extension portion G12 on the base substrate. In an exemplary embodiment, the overlap area between the orthographic projection on the base substrate of the first gate line G1 and the orthographic projection on the base substrate of the ninth active portion 89 in the first pixel driving circuit P1 may be smaller than the overlap area between the orthographic projection on the base substrate of the first gate line G1 and the orthographic projection on the base substrate of the ninth active portion 89 in the second pixel driving circuit P2.

As shown in Figs. 3, 6, 8, 17, and 18, in an exemplary embodiment, the orthographic projection of the ninth active portion 89 on the base substrate is located on the orthographic projection of the second extension portion G12 on the base substrate. The size in the first direction X of the orthographic projection on the base substrate of the ninth active portion 89 in the first pixel driving circuit P1 is smaller than the size in the first direction X of the orthographic projection on the base substrate of the ninth active portion 89 in the second pixel driving circuit P2.

It should be understood that the equipotential structure of the gate of the driving transistor T3 may also include other structures. For example, the equipotential structure of the gate of the driving transistor T3 may also include a first bridge portion 41. The equipotential structure of the gate of the driving transistor T3 connected to the first conductive portion may form a second conductive portion. In an exemplary embodiment, the differentiated setting of C1 and C2 can be achieved by adjusting the overlap area between the second conductive portion and the second extension portion G12 on the base substrate. For example, in an exemplary embodiment, the overlap area between the orthographic projection on the base substrate of the first gate line G1 and the orthographic projection on the base substrate of the second conductive portion in the first pixel driving circuit P1 is S1, and the overlap area between the orthographic projection on the base substrate of the first gate line and the orthographic projection on the base substrate of the second conductive portion in the second pixel driving circuit is S2, where S1 may be smaller than S2.

In addition, in other exemplary embodiments, the differentiated setting of C1 and C2 can also be achieved in other ways. For example, the capacitance between the second conductive portion and the first gate line can be adjusted by adjusting the distance between the second conductive portion and the first gate line at the overlap part between the orthographic projections on the base substrate.

As shown in Figs. 3, 11, and 19, the fifth conductive layer may include a data line Da, a power line 5VDD, and a sixth bridge portion 56. The data line Da may be used to provide the data signal terminal in Fig. 1, and the power line 5VDD may be used to provide the first power terminal in Fig. 1. The orthographic projection of the data line Da on the base substrate and the orthographic projection of the power line 5VDD on the base substrate may extend along the second direction Y. The data line Da may be connected to the fifth bridge portion 45 through a via hole, so as to connect the first terminal of the fourth transistor T4 and the data signal terminal. A power line 5VDD may be correspondingly arranged for each column of pixel driving circuits. The power line 5VDD may be connected to the first power line segment 4VDD through a via hole, so as to connect the first power terminal with the second electrode of the capacitor C and the first terminal of the fifth transistor T5. The sixth bridge portion 56 may be connected to the third bridge portion 43 through a via hole, so as to connect the second terminal of the sixth transistor T6.

As shown in Figs. 3, 11, and 19, the orthographic projection of the power line 5VDD on the base substrate may cover the orthographic projection of the active portion 8 on the base substrate. The power line 5VDD can reduce the influence of light on the characteristics of the eighth transistor T8. In addition, the orthographic projection of the power line 5VDD on the base substrate may also cover the orthographic projections of the ninth active portion 89 and the first bridge portion 41 on the base substrate. The power line 5VDD may be used to shield the noise interference of other signals on the ninth active portion 89 and the first bridge portion 41, thereby improving the stability of the voltage at the gate of the driving transistor T3. The orthographic projection of the power line 5VDD on the base substrate may cover the orthographic projection of the second conductive portion on the base substrate.

In an exemplary embodiment, the display panel may also include a source driving circuit. A signal output terminal of the source driving circuit may be connected to a plurality of data lines. A signal output terminal of the source driving circuit may provide data signals to a plurality of data lines in a time-division way within a row scanning cycle. The plurality of data lines need to provide data signals to the scanning pixel row at the same time during the data writing stage. Therefore, the data line needs to have a certain data storage capacity. As shown in Figs. 3, 10, 11, and 19, the first power line segment 4VDD may include a third extension portion 4VDD3. The orthographic projection of the third extension portion 4VDD3 on the base substrate and the orthographic projection of the data line Da on the base substrate at least partially overlap. This setting can form a parasitic capacitor between the data line Da and the third extension portion 4VDD3, thereby enabling the data line to have a certain data storage capacity. In an exemplary embodiment, the orthographic projection of the data line Da on the base substrate has an area of S3, and the overlap area between the orthographic projection of the data line Da on the base substrate and the orthographic projection of the third extension portion 4VDD3 on the base substrate is S4, where S4/S3 is greater than or equal to 20% and less than or equal to 70%. For example, S4/S3 may be equal to 20%, 30%, 40%, 50%, 60%, or 70%.

As shown in Figs. 3, 10, 11, and 19, the first power line segment 4VDD may also include a fourth extension portion 4VDD4. The orthographic projection of the fourth extension portion 4VDD4 on the base substrate extends along the second direction Y, and is located between the orthographic projection of the data line Da on the base substrate and the orthographic projection of the second conductive portion on the base substrate. For example, when the second conductive portion includes the ninth active portion 89 and the first bridge portion 41, the orthographic projection of the fourth extension portion 4VDD4 on the base substrate is located between the orthographic projection of the data line Da on the base substrate and the orthographic projections of the ninth active portion 89 and the first bridge portion 41 on the base substrate. This setting can shield the noise influence of the data signal at the data line Da on the gate of the driving transistor through the fourth extension portion 4VDD4.

As shown in Figs. 3, 11, and 19, the size in the first direction X of the orthographic projection of the third extension portion 4VDD3 on the base substrate may be larger than the size in the first direction X of the orthographic projection of the fourth extension portion 4VDD4 on the base substrate. The orthographic projection of a partial structure of the third extension portion 4VDD3 on the base substrate may also be located between the orthographic projection of the second conductive portion on the base substrate and the orthographic projection of the data line Da on the base substrate. For example, the orthographic projection of a partial structure of the third extension portion 4VDD3 on the base substrate is located between the orthographic projection of the first bridge portion 41 on the base substrate and the orthographic projection of the data line Da on the base substrate. This setting can also shield the noise influence of the data signal at the data line Da on the gate of the driving transistor.

In an exemplary embodiment, the first power line segment 4VDD is connected to the power line 5VDD through a via hole. It should be understood that in other exemplary embodiments, the first power line segment 4VDD may also be connected to other stable voltage terminals. For example, the first power line segment 4VDD may also be connected to the first initial signal terminal, the second initial signal terminal, etc.

As shown in Figs. 3, 11, and 19, the fourth conductive layer may further include a first connecting portion 46, and the first connecting portion 46 is connected between two adjacent first power line segments 4VDD in the first direction X. The first power line segments 4VDD connected in the first direction X may form a grid structure with the power line 5VDD. The power line of the grid structure has a small resistance. Thus, the voltage difference between the first power terminals at different positions of the display panel can be reduced, thereby improving the display uniformity of the display panel.

It should be noted that in an exemplary embodiment, the design of the first power line segment 4VDD forming a parasitic capacitor with the data line, and the design of the first power line segment 4VDD shielding the data line from introducing noise influence on the gate of the driving transistor, may be applied to display panels of any other architectures. This design is not limited to other film layers and other film layer structures. As long as the display panel includes a power line and a data line, the first power line segment 4VDD located in a different film layer from the power line and the data line may be used to form a parasitic capacitor with the data line, and to shield the noise interference of the data line on the gate of the driving transistor.

In an exemplary embodiment, the voltage required for the first light-emitting unit to emit light is greater than the voltage required for the second light-emitting unit to emit light. Accordingly, the width-to-length ratio of the channel region of the driving transistor in the first pixel driving circuit P1 may be greater than the width-to-length ratio of the channel region of the driving transistor in the second pixel driving circuit P2. For example, the length of the channel region of the driving transistor in the first pixel driving circuit P1 may be less than the length of the channel region of the driving transistor in the second pixel driving circuit P2. This setting can reduce the impedance of the driving transistor, thereby increasing the voltage division between the first power terminal VDD and the second power terminal VSS of the light-emitting unit L. That is, with the same data signal, this setting can enable the voltage at both sides of the first light-emitting unit to be greater than the voltage at both sides of the second light-emitting unit. Also, this setting can meet the requirement that the voltage required for the first light-emitting unit to emit light is greater than the voltage required for the second light-emitting unit to emit light.

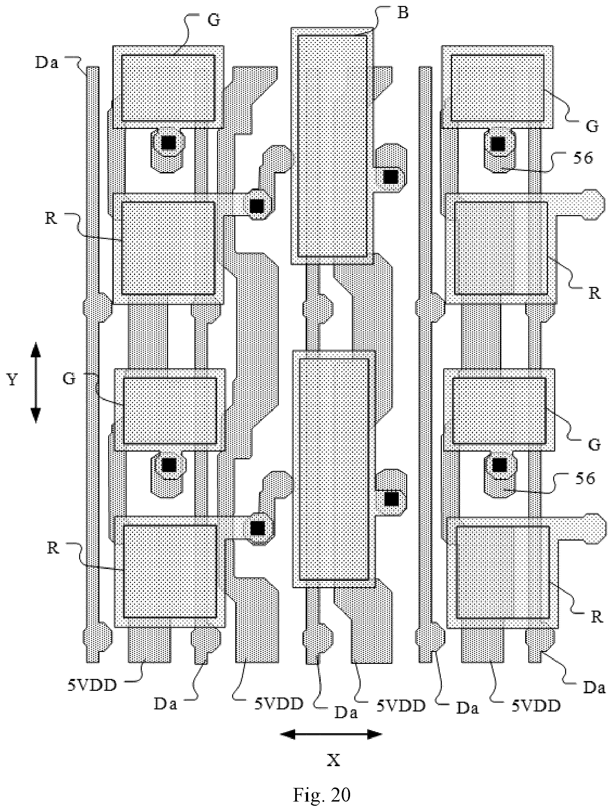

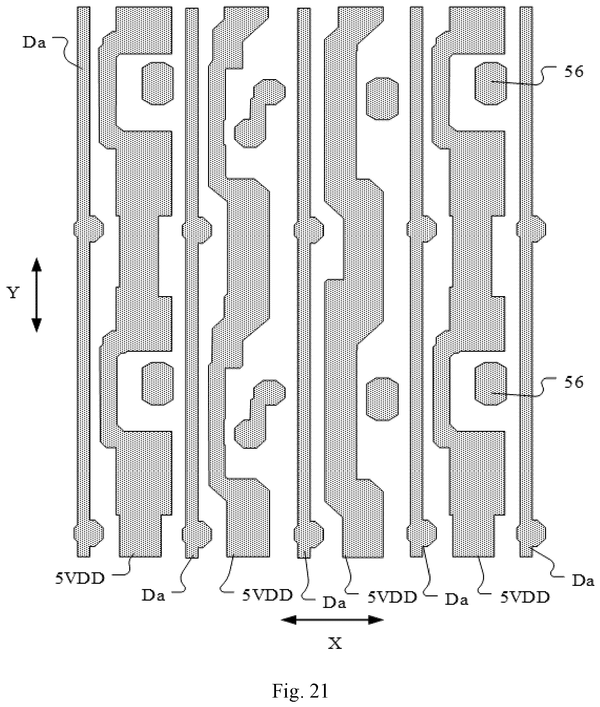

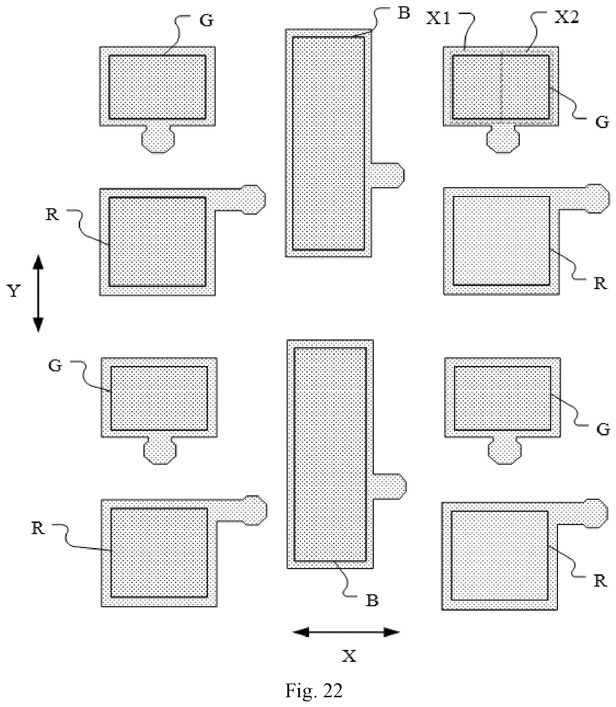

As shown in Figs. 3, 12, 20, 21, and 22, Fig. 20 is a structural layout of the fifth conductive layer and the electrode layer in a display panel according to an exemplary embodiment of the present disclosure, Fig. 21 is a structural layout of the fifth conductive layer in Fig. 20, and Fig. 22 is a structural layout of the electrode layer in Fig. 20. In an exemplary embodiment, the electrode layer may include a plurality of electrode portions: a first electrode portion R, a second electrode portion B, and a third electrode portion G. Each of the electrode portions may be connected to the sixth bridge portion 56 through a via hole so as to connect the second terminal of the sixth transistor T6. The first electrode portion R may be used to form a first electrode of a red light-emitting unit, the second electrode portion B may be used to form a first electrode of a blue light-emitting unit, and the third electrode portion G may be used to form a first electrode of a green light-emitting unit. The display panel may further include a pixel definition layer located on the side of the electrode layer away from the base substrate. A pixel opening used for forming a light-emitting unit is provided on the pixel definition layer. The orthographic projection on the base substrate of the first electrode portion R coincides with the orthographic projection on the base substrate of the pixel opening corresponding thereto on the pixel definition layer. The orthographic projection on the base substrate of the second electrode portion B coincides with the orthographic projection on the base substrate of the pixel opening corresponding thereto on the pixel definition layer. The orthographic projection on the base substrate of the third electrode portion G coincides with the orthographic projection on the base substrate of the pixel opening corresponding thereto on the pixel definition layer.

In an exemplary embodiment, the orthographic projection of each electrode portion on the base substrate overlaps with the orthographic projection of the power line 5VDD on the base substrate and the orthographic projection of the data line Da on the base substrate. This setting enables as many of the electrode portions as possible to be located on the fifth conductive layer, thereby improving the flatness of the electrode portion to reduce the risk of color shift of the display panel at different viewing angles. In an exemplary embodiment, the minimum size in the first direction X of the overlap part between the orthographic projection of the electrode portion on the base substrate and the orthographic projection of the power line 5VDD on the base substrate is L1, and the minimum size in the first direction X of the orthographic projection of the data line Da on the base substrate may be L2, where L1 may be greater than L2. For example, L1/L2 may be equal to 1.5, 2, 3, 4, etc. This setting can further improve the flatness of the electrode portion.

In an exemplary embodiment, the electrode portion may include a first part X1 and a second part X2. The orthographic projection of the first part X1 on the base substrate and the orthographic projection of the second part X2 on the base substrate may be arranged along the first direction X. The maximum size in the first direction X of the orthographic projection of the first part X1 on the base substrate is equal to the maximum size in the first direction X of the orthographic projection of the second part X2 on the base substrate. The orthographic projection of the first part X1 on the base substrate and the orthographic projection of the power line 5VDD on the base substrate at least partially overlap. The orthographic projection of the second part X2 on the base substrate and the orthographic projection of the data line Da on the base substrate at least partially overlap. This setting enables both sides of the electrode portion in the first direction X to be located on the fifth conductive layer, thereby further improving the flatness of the electrode portion.

In an exemplary embodiment, the first light-emitting unit may be a blue light-emitting unit, and the second light-emitting unit may be a red light-emitting unit. In addition, the second light-emitting unit may also be a green light-emitting unit. That is, the pixel driving circuit corresponding to the green light-emitting unit may have all the features of the above-mentioned second pixel driving circuit.

It should be noted that, as shown in Figs. 3, 18, 19, and 20, the black square shown at the side of the fourth conductive layer away from the base substrate indicates the via hole through which the fourth conductive layer is connected to other layers facing the side of the base substrate. The black square shown at the side of the fifth conductive layer away from the base substrate indicates the via hole through which the fifth conductive layer is connected to other layers facing the side of the base substrate. The black square shown at the side of the electrode layer away from the base substrate indicates the via hole through which the electrode layer is connected to other layers facing the side of the base substrate. The black square indicates the position of the via hole. Different via holes represented by the black squares at different positions may pass through different insulation layers.

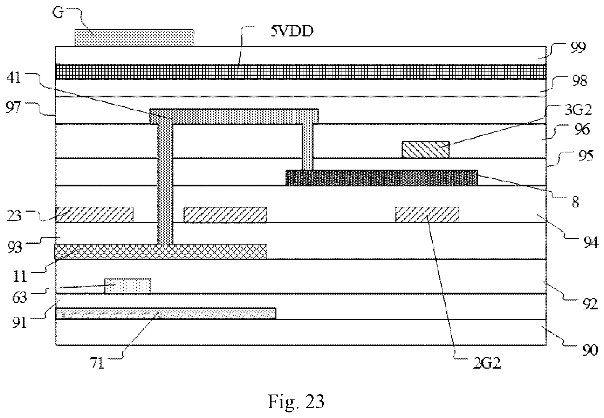

As shown in Fig. 23, it is a partial cross-sectional view along the dotted line AA of the display panel shown in Fig. 3. The display panel may further include a first insulation layer 91, a second insulation layer 92, a third insulation layer 93, a fourth insulation layer 94, a fifth insulation layer 95, a first dielectric layer 96, a passivation layer 97, a first planarization layer 98, and a second planarization layer 99. The base substrate 90, the shielding layer, the first insulation layer 91, the first active layer, the second insulation layer 92, the first conductive layer, the third insulation layer 93, the second conductive layer, the fourth insulation layer 94, the second active layer, the fifth insulation layer 95, the third conductive layer, the first dielectric layer 96, the fourth conductive layer, the passivation layer 97, the first planarization layer 98, the fifth conductive layer, the second planarization layer 99, and the electrode layer are stacked in sequence. The first insulation layer 91, the second insulation layer 92, the third insulation layer 93, the fourth insulation layer 94, and the fifth insulation layer 95 may be a single-layer structure or a multi-layer structure. The materials of the first insulation layer 91, the second insulation layer 92, the third insulation layer 93, the fourth insulation layer 94, and the fifth insulation layer 95 may be at least one of silicon nitride, silicon oxide, and silicon oxynitride. The first dielectric layer 96 may be a silicon nitride layer. The materials of the first planarization layer 98 and the second planarization layer 99 may be organic materials, such as polyimide (PI), polyethylene terephthalate (PET), polyethylene naphthalate (PEN), silicon-glass bonding structure (SOG), etc. The base substrate 90 may include a glass substrate, a barrier layer, and a polyimide layer stacked in sequence. The barrier layer may be an inorganic material. The passivation layer 97 may be a silicon oxide layer. The materials of the first conductive layer, the second conductive layer, and the third conductive layer may be one of molybdenum, aluminum, copper, titanium, and niobium, or an alloy thereof, or may be a molybdenum/titanium alloy or laminate, etc. The materials of the fourth conductive layer and the fifth conductive layer may include metal materials, for example, one of molybdenum, aluminum, copper, titanium, niobium or an alloy thereof, or a molybdenum/titanium alloy or laminate, or a titanium/aluminum/titanium laminate. The electrode layer may include an indium tin oxide layer and a silver layer. The square resistance of any one of the first conductive layer, the second conductive layer, and the third conductive layer may be greater than the square resistance of any one of the fourth conductive layer and the fifth conductive layer.

It should be noted that the proportions in the drawings in the present disclosure may be used as a reference in the actual process, but are not limited to this. For example, the width-to-length ratio of the channel, the thickness and spacing of each film layer, and the width and spacing of each signal line may be adjusted according to actual needs. The number of pixels in the display substrate and the number of sub-pixels in each pixel are not limited to the number shown in the figures. The drawings described in the present disclosure are only schematic structure diagrams. In addition, the first, second, and other qualifiers are only used to define different structure names, and they do not have a specific order and quantity. In an exemplary embodiment, the orthographic projection of a certain structure on the base substrate extends in a certain direction, which may be understood as the orthographic projection of the structure on the base substrate extending in a straight line or bending along the direction. A transistor refers to an element including at least three terminals: a gate, a drain, and a source. A transistor has a channel region between a drain (drain electrode terminal, drain region, or drain electrode) and a source (source electrode terminal, source region, or source electrode), and current can flow through the drain, the channel region, and the source. In an exemplary embodiment, the channel region refers to a region where current mainly flows. In an exemplary embodiment, the first terminal may be a drain, the second terminal may be a source. Alternatively, the first terminal may be a source, and the second terminal may be a drain. In the case of using transistors with opposite polarities or when the current direction changes during circuit operation, the functions of the "source" and the "drain" are sometimes interchanged. Therefore, in an exemplary embodiment, the "source" and the "drain" may be interchanged. In addition, the gate may also be referred to as a control terminal.

An exemplary embodiment also provides a display device, which includes the above-mentioned display panel. The display device may be a display device such as a mobile phone, a tablet computer, a television, etc.

After considering the specification and practicing the contents disclosed herein, those skilled in the art shall easily think of other embodiments of the present disclosure. The present application is intended to cover any variation, use or adaptation of the present disclosure, which follows the general principles of the present disclosure and includes common knowledge or customary technical means in the technical field that are not disclosed in the present disclosure. The description and embodiments are only to be regarded as exemplary, and the true scope of the present disclosure are indicated by the claims.

The drawings in the present disclosure only relate to the structures involved in the present disclosure, and other structures may refer to the general design. In the absence of conflict, the embodiments of the present disclosure and the features in the embodiments may be combined with each other to obtain new embodiments.

It should be understood that the present disclosure is not limited to the precise structures described above and shown in the drawings, and various modifications and changes may be made without departing from the scope of the present disclosure. The scope of the present disclosure is limited only by the attached claims.

## Claims

1. A display panel, comprising a plurality of pixel driving circuits, wherein the pixel driving circuit comprises a driving transistor (T3) and a fourth transistor (T4), the fourth transistor (T4) has a first terminal connected to a data line (Da), a second terminal connected to a first terminal of the driving transistor (T3), and a gate connected to a first gate line (G1), **characterized in that**
the plurality of pixel driving circuits comprises a first pixel driving circuit and a second pixel driving circuit;
a capacitance formed by the first gate line (G1) and an equipotential structure of a gate of the driving transistor (T3) in the first pixel driving circuit is C1, and a capacitance formed by the first gate line (G1) and the equipotential structure of the gate of the driving transistor (T3) in the second pixel driving circuit is C2, where C1 is not equal to C2.

2. The display panel according to claim 1, further comprising a plurality of light-emitting units, wherein
the plurality of light-emitting units comprises a first light-emitting unit and a second light-emitting unit;
the first pixel driving circuit is used to drive the first light-emitting unit, and the second pixel driving circuit is used to drive the second light-emitting unit;
with a same driving current, a brightness of the first light-emitting unit is less than a brightness of the second light-emitting unit, and C1 is less than C2.

3. The display panel according to claim 2, further comprising:
a base substrate;
a first active layer located on a side of the base substrate, wherein the first active layer comprises a third active portion (63), and the third active portion (63) is used to form a channel region of the driving transistor (T3);
a first conductive layer located on a side of the first active layer away from the base substrate, wherein the first conductive layer comprises a first conductive portion (11), an orthographic projection of the first conductive portion (11) on the base substrate covers an orthographic projection of the third active portion (63) on the base substrate, and the first conductive portion (11) is used to form the gate of the driving transistor (T3);
a second conductive portion arranged corresponding to the first conductive portion (11), wherein the second conductive portion is connected to the first conductive portion (11) corresponding thereto, an overlap area between an orthographic projection on the base substrate of the first gate line (G1) and an orthographic projection on the base substrate of the second conductive portion in the first pixel driving circuit is S1, and an overlap area between the orthographic projection on the base substrate of the first gate line (G1) and the orthographic projection on the base substrate of the second conductive portion in the second pixel driving circuit is S2, where S1 is less than S2.

4. The display panel according to claim 3, wherein
the pixel driving circuit further comprises an eighth transistor (T8), a first terminal of the eighth transistor (T8) being connected to the gate of the driving transistor (T3); and
the display panel further comprises:
a second active layer located on a side of the first conductive layer away from the base substrate, wherein the second active layer comprises an eighth active portion (88) and a ninth active portion (89) connected to each other, and the eighth active portion (88) is used to form a channel region of the eighth transistor (T8), wherein
the ninth active portion (89) is connected to the first conductive portion (11), the second conductive portion comprises the ninth active portion (89), and an overlap area between the orthographic projection on the base substrate of the first gate line (G1) and an orthographic projection on the base substrate of the ninth active portion (89) in the first pixel driving circuit is smaller than an overlap area between the orthographic projection on the base substrate of the first gate line (G1) and the orthographic projection on the base substrate of the ninth active portion (89) in the second pixel driving circuit.

5. The display panel according to claim 3, wherein
the first conductive layer comprises the first gate line (G1), and the orthographic projection of the first gate line (G1) on the base substrate extends along a first direction; and
the first gate line (G1) comprises:
a plurality of first extension portions (G11), wherein orthographic projections of the plurality of first extension portions (G11) on the base substrate extend along the first direction and are spaced apart along the first direction;
a plurality of second extension portions (G12), wherein the second extension portions (G12) is connected between adjacent first extension portions (G11) in the first direction, wherein
a size in a second direction of the orthographic projection of the first extension portion (G11) on the base substrate is smaller than a size in the second direction of an orthographic projection of the second extension portion (G12) on the base substrate, wherein the first direction and the second direction intersect; and
the orthographic projection of the second conductive portion on the base substrate and the orthographic projection of the second extension portion (G12) on the base substrate at least partially overlap.

6. The display panel according to claim 5, wherein
the pixel driving circuit further comprises an eighth transistor (T8), a first terminal of the eighth transistor (T8) is connected to the gate of the driving transistor (T3), and the display panel further comprises:
a second active layer located on a side of the first conductive layer away from the base substrate, wherein the second active layer comprises an eighth active portion (88) and a ninth active portion (89) connected to each other, and the eighth active portion (88) is used to form a channel region of the eighth transistor (T8), wherein
the ninth active portion (89) is connected to the first conductive portion (11), the second conductive portion comprises the ninth active portion (89), an orthographic projection of the ninth active portion (89) on the base substrate is located on the orthographic projection of the second extension portion (G12) on the base substrate; and
a size in the first direction of the orthographic projection on the base substrate of the ninth active portion (89) in the first pixel driving circuit is smaller than a size in the first direction of the orthographic projection on the base substrate of the ninth active portion (89) in the second pixel driving circuit.

7. The display panel according to claim 1, wherein
the plurality of pixel driving circuits is arranged along the first direction and the second direction, and
the display panel further comprises:
a base substrate;
a fourth conductive layer located on a side of the base substrate, wherein the fourth conductive layer comprises a plurality of first power line segments (4VDD), the first power line segments (4VDD) are arranged corresponding to the pixel driving circuits, orthographic projections of the plurality of first power line segments (4VDD) on the base substrate are arrarnged along the first direction and the second direction and extend along the second direction, the first direction and the second direction intersect, and the first power line segments (4VDD) are connected to a stable voltage source;
a fifth conductive layer located on a side of the fourth conductive layer away from the base substrate, wherein the fifth conductive layer comprises the data line (Da), and an orthographic projection of the data line (Da) on the base substrate extends along the second direction.

8. The display panel according to claim 7, wherein
the pixel driving circuit further comprises an eighth transistor (T8), a first terminal of the eighth transistor (T8) is connected to the gate of the driving transistor (T3), and the display panel further comprises:
a second active layer located between the fourth conductive layer and the base substrate, wherein the second active layer comprises an eighth active portion (88), and the eighth active portion (88) is used to form a channel region of the eighth transistor (T8);
a third conductive layer located between the second active layer and the fourth conductive layer, wherein the third conductive layer comprises a second gate line (3G2), an orthographic projection of the second gate line (3G2) on the base substrate extends along the first direction and covers an orthographic projection of the eighth active portion (88) on the base substrate, and a partial structure of the second gate line (3G2) is used to form a top gate of the eighth transistor (T8),
wherein the orthographic projection of the first power line segment (4VDD) on the base substrate is located between the orthographic projections of two adjacent second gate lines (3G2) on the base substrate.

9. The display panel according to claim 7, further comprising a source driving circuit, wherein
a signal output terminal of the source driving circuit is connected to the plurality of data lines (Da), and the signal output terminal of the source driving circuit provides data signals to the plurality of data lines (Da) in a time-division way within a row scanning cycle; and
the first power line segment (4VDD) comprises a third extension portion (4VDD3), wherein an orthographic projection of the third extension portion (4VDD3) on the base substrate and the orthographic projection of the data line (Da) on the base substrate at least partially overlap.

10. The display panel according to claim 7, wherein
the first terminal of the driving transistor (T3) is connected to a power line (5VDD);
the fourth conductive layer further comprises a first connecting portion (46), wherein the first connecting portion (46) is connected between two adjacent first power line segments (4VDD) in the first direction;
the fifth conductive layer further comprises the power line, wherein an orthographic projection of the power line on the base substrate extends along the second direction, and the power line is used to provide the stable voltage source.

11. The display panel according to claim 7, wherein
the first power line segment (4VDD) further comprises a fourth extension portion (4VDD4);
the display panel further comprises a second conductive portion, the second conductive portion being connected to the gate of the driving transistor (T3);
an orthographic projection of the fourth extension portion on the base substrate extends along the second direction, and is located between the orthographic projection of the data line (Da) on the base substrate and an orthographic projection of the second conductive portion on the base substrate.

12. The display panel according to claim 1, wherein
the first terminal of the driving transistor (T3) is connected to a power line, the pixel driving circuit further comprises an eighth transistor (T8), a first terminal of the eighth transistor (T8) is connected to the gate of the driving transistor (T3), and the display panel further comprises:
a base substrate;
a second active layer located on a side of the base substrate, wherein the second active layer comprises an active portion, and a partial structure of the active portion is used to form a channel region of the eighth transistor (T8);
a fifth conductive layer located on a side of the second active layer away from the base substrate, wherein the fifth conductive layer comprises the power line, and an orthographic projection of the power line on the base substrate covers an orthographic projection of the active portion on the base substrate.

13. The display panel according to claim 1, wherein
the first terminal of the driving transistor (T3) is connected to a power line (5VDD), and the display panel further comprises:
a base substrate;
a second conductive portion, the second conductive portion being connected to the gate of the driving transistor (T3);
a fifth conductive layer located on a side of the base substrate, wherein the fifth conductive layer comprises the power line (5VDD), and an orthographic projection of the power line (5VDD) on the base substrate covers an orthographic projection of the second conductive portion on the base substrate.

14. The display panel according to claim 1, wherein
the first terminal of the driving transistor (T3) is connected to a power line (5VDD), and the display panel further comprises:
a base substrate;
a fifth conductive layer located on a side of the base substrate, wherein the fifth conductive layer comprises the power line (5VDD) and the data line (Da), and an orthographic projection of the power line (5VDD) on the base substrate and an orthographic projection of the data line (Da) on the base substrate extend along a second direction;
an electrode layer comprising a plurality of electrode portions, wherein an orthographic projection of the electrode portion on the base substrate overlaps with the orthographic projection of the power line (5VDD) on the base substrate and the orthographic projection of the data line (Da) on the base substrate;
a pixel definition layer located on a side of the electrode layer away from the base substrate, wherein a pixel opening used for forming a light-emitting unit is provided on the pixel definition layer, and an orthographic projection of the pixel opening on the base substrate coincides with the orthographic projection of the electrode portion on the base substrate.

15. A display device, comprising the display panel according to any one of claims 1 to 14.

## Patentansprüche

1. Anzeigefeld, umfassend eine Vielzahl von Pixelansteuerschaltungen, wobei die Pixelansteuerschaltung einen Ansteuertransistor (T3) und einen vierten Transistor (T4) umfasst, wobei der vierte Transistor (T4) einen ersten Anschluss, der mit einer Datenleitung (Da) verbunden ist, einen zweiten Anschluss, der mit einem ersten Anschluss des Ansteuertransistors (T3) verbunden ist, und ein Gate aufweist, das mit einer ersten Gate-Leitung (G1) verbunden ist, **dadurch gekennzeichnet, dass**
die Vielzahl von Pixelansteuerschaltungen eine erste Pixelansteuerschaltung und eine zweite Pixelansteuerschaltung umfasst;
eine Kapazität, die durch die erste Gate-Leitung (G1) und eine Äquipotenzialstruktur eines Gates des Ansteuertransistors (T3) in der ersten Pixelansteuerschaltung gebildet wird, C1 ist, und eine Kapazität, die durch die erste Gate-Leitung (G1) und die Äquipotenzialstruktur des Gates des Ansteuertransistors (T3) in der zweiten Pixelansteuerschaltung gebildet wird, C2 ist, wobei C1 nicht gleich C2 ist.

2. Anzeigefeld nach Anspruch 1, ferner umfassend eine Vielzahl von lichtemittierenden Einheiten, wobei
die Vielzahl der lichtemittierenden Einheiten eine erste lichtemittierende Einheit und eine zweite lichtemittierende Einheit umfasst;
die erste Pixelansteuerschaltung zum Ansteuern der ersten lichtemittierenden Einheit verwendet wird und die zweite Pixelansteuerschaltung zum Ansteuern der zweiten lichtemittierenden Einheit verwendet wird;
bei einem gleichen Ansteuerstrom eine Helligkeit der ersten lichtemittierenden Einheit geringer als eine Helligkeit der zweiten lichtemittierenden Einheit ist und C1 kleiner als C2 ist.

3. Anzeigefeld nach Anspruch 2, ferner umfassend:
ein Basissubstrat;
eine erste aktive Schicht, die auf einer Seite des Basissubstrats angeordnet ist, wobei die erste aktive Schicht einen dritten aktiven Abschnitt (63) umfasst und der dritte aktive Abschnitt (63) verwendet wird, um eine Kanalregion des Ansteuertransistors (T3) zu bilden;
eine erste leitfähige Schicht, die auf einer dem Basissubstrat abgewandten Seite der ersten aktiven Schicht angeordnet ist, wobei die erste leitfähige Schicht einen ersten leitfähigen Abschnitt (11) umfasst, eine orthografische Projektion des ersten leitfähigen Abschnitts (11) auf das Basissubstrat eine orthografische Projektion des dritten aktiven Abschnitts (63) auf das Basissubstrat bedeckt und der erste leitfähige Abschnitt (11) verwendet wird, um das Gate des Ansteuertransistors (T3) zu bilden;
einen zweiten leitfähigen Abschnitt, der entsprechend dem ersten leitfähigen Abschnitt (11) angeordnet ist, wobei der zweite leitfähige Abschnitt mit dem dazu entsprechenden ersten leitfähigen Abschnitt (11) verbunden ist, ein Überlappungsbereich zwischen einer orthografischen Projektion der ersten Gate-Leitung (G1) auf das Basissubstrat und einer orthografischen Projektion des zweiten leitfähigen Abschnitts in der ersten Pixelansteuerschaltung auf das Basissubstrat S1 ist und ein Überlappungsbereich zwischen der orthografischen Projektion der ersten Gate-Leitung (G1) auf das Basissubstrat und der orthografischen Projektion des zweiten leitfähigen Abschnitts in der zweiten Pixelansteuerschaltung auf das Basissubstrat S2 ist, wobei S1 kleiner als S2 ist.

4. Anzeigefeld nach Anspruch 3, wobei
die Pixelansteuerschaltung ferner einen achten Transistor (T8) umfasst, wobei ein erster Anschluss des achten Transistors (T8) mit dem Gate des Ansteuertransistors (T3) verbunden ist; und
das Anzeigefeld ferner umfasst:
eine zweite aktive Schicht, die auf einer dem Basissubstrat abgewandten Seite der ersten leitfähigen Schicht angeordnet ist, wobei die zweite aktive Schicht einen achten aktiven Abschnitt (88) und einen neunten aktiven Abschnitt (89) umfasst, die miteinander verbunden sind, und der achte aktive Abschnitt (88) verwendet wird, um eine Kanalregion des achten Transistors (T8) zu bilden, wobei
der neunte aktive Abschnitt (89) mit dem ersten leitfähigen Abschnitt (11) verbunden ist, der zweite leitfähige Abschnitt den neunten aktiven Abschnitt (89) umfasst und ein Überlappungsbereich zwischen der orthografischen Projektion der ersten Gate-Leitung (G1) auf das Basissubstrat und einer orthografischen Projektion des neunten aktiven Abschnitts (89) auf das Basissubstrat in der ersten Pixelansteuerschaltung kleiner als ein Überlappungsbereich zwischen der orthografischen Projektion der ersten Gate-Leitung (G1) auf das Basissubstrat und der orthografischen Projektion des neunten aktiven Abschnitts (89) auf das Basissubstrat in der zweiten Pixelansteuerschaltung ist.

5. Anzeigefeld nach Anspruch 3, wobei
die erste leitfähige Schicht die erste Gate-Leitung (G1) umfasst und die orthografische Projektion der ersten Gate-Leitung (G1) auf das Basissubstrat sich entlang einer ersten Richtung erstreckt; und
die erste Gate-Leitung (G1) umfasst:
eine Vielzahl von ersten Erstreckungsabschnitten (G11), wobei sich orthografische Projektionen der Vielzahl von ersten
Erstreckungsabschnitten (G11) auf das Basissubstrat entlang der ersten Richtung erstrecken und entlang der ersten Richtung beabstandet sind;
eine Vielzahl von zweiten Erstreckungsabschnitten (G12), wobei die zweiten Erstreckungsabschnitte (G12) zwischen benachbarten ersten Erstreckungsabschnitten (G11) in der ersten Richtung verbunden sind, wobei
eine Größe in einer zweiten Richtung der orthografischen Projektion des ersten Erstreckungsabschnitts (G11) auf das Basissubstrat kleiner als eine Größe in der zweiten Richtung einer orthografischen Projektion des zweiten Erstreckungsabschnitts (G12) auf das Basissubstrat ist, wobei sich die erste Richtung und die zweite Richtung schneiden; und
die orthografische Projektion des zweiten leitfähigen Abschnitts auf das Basissubstrat und die orthografische Projektion des zweiten Erstreckungsabschnitts (G12) auf das Basissubstrat sich mindestens teilweise überlappen.

6. Anzeigefeld nach Anspruch 5, wobei
die Pixelansteuerschaltung ferner einen achten Transistor (T8) umfasst, ein erster Anschluss des achten Transistors (T8) mit dem Gate des Ansteuertransistors (T3) verbunden ist und das Anzeigefeld ferner umfasst:
eine zweite aktive Schicht, die auf einer dem Basissubstrat abgewandten Seite der ersten leitfähigen Schicht angeordnet ist, wobei die zweite aktive Schicht einen achten aktiven Abschnitt (88) und einen neunten aktiven Abschnitt (89) umfasst, die miteinander verbunden sind, und der achte aktive Abschnitt (88) verwendet wird, um eine Kanalregion des achten Transistors (T8) zu bilden, wobei
der neunte aktive Abschnitt (89) mit dem ersten leitfähigen Abschnitt (11) verbunden ist, der zweite leitfähige Abschnitt den neunten aktiven Abschnitt (89) umfasst, eine orthografische Projektion des neunten aktiven Abschnitts (89) auf das Basissubstrat auf der orthografischen Projektion des zweiten Erstreckungsabschnitts (G12) auf das Basissubstrat angeordnet ist; und
eine Größe in der ersten Richtung der orthografischen Projektion des neunten aktiven Abschnitts (89) in der ersten Pixelansteuerschaltung auf das Basissubstrat kleiner als eine Größe in der ersten Richtung der orthografischen Projektion des neunten aktiven Abschnitts (89) in der zweiten Pixelansteuerschaltung auf das Basissubstrat ist.

7. Anzeigefeld nach Anspruch 1, wobei
die Vielzahl von Pixelansteuerschaltungen entlang der ersten Richtung und der zweiten Richtung angeordnet ist und
das Anzeigefeld ferner umfasst:
ein Basissubstrat;
eine vierte leitfähige Schicht, die auf einer Seite des Basissubstrats angeordnet ist, wobei die vierte leitfähige Schicht eine Vielzahl von ersten Stromleitungssegmenten (4VDD) umfasst, wobei die ersten Stromleitungssegmente (4VDD) entsprechend den Pixelansteuerschaltungen angeordnet sind, orthografische Projektionen der Vielzahl von ersten Stromleitungssegmenten (4VDD) auf das Basissubstrat entlang der ersten Richtung und der zweiten Richtung angeordnet sind und sich entlang der zweiten Richtung erstrecken, die erste Richtung und die zweite Richtung sich schneiden und die ersten Stromleitungssegmente (4VDD) mit einer stabilen Spannungsquelle verbunden sind;
eine fünfte leitfähige Schicht, die auf einer dem Basissubstrat abgewandten Seite der vierten leitfähigen Schicht angeordnet ist, wobei die fünfte leitfähige Schicht die Datenleitung (Da) umfasst und eine orthografische Projektion der Datenleitung (Da) auf das Basissubstrat sich entlang der zweiten Richtung erstreckt.

8. Anzeigefeld nach Anspruch 7, wobei
die Pixelansteuerschaltung ferner einen achten Transistor (T8) umfasst, ein erster Anschluss des achten Transistors (T8) mit dem Gate des Ansteuertransistors (T3) verbunden ist und das Anzeigefeld ferner umfasst:
eine zweite aktive Schicht, die zwischen der vierten leitfähigen Schicht und dem Basissubstrat angeordnet ist, wobei die zweite aktive Schicht einen achten aktiven Abschnitt (88) umfasst und der achte aktive Abschnitt (88) verwendet wird, um eine Kanalregion des achten Transistors (T8) zu bilden;
eine dritte leitfähige Schicht, die zwischen der zweiten aktiven Schicht und der vierten leitfähigen Schicht angeordnet ist, wobei die dritte leitfähige Schicht eine zweite Gate-Leitung (3G2) umfasst, eine orthografische Projektion der zweiten Gate-Leitung (3G2) auf das Basissubstrat sich entlang der ersten Richtung erstreckt und eine orthografische Projektion des achten aktiven Abschnitts (88) auf das Basissubstrat bedeckt und eine Teilstruktur der zweiten Gate-Leitung (3G2) verwendet wird, um ein oberes Gate des achten Transistors (T8) zu bilden,
wobei die orthografische Projektion des ersten
Stromleitungssegments (4VDD) auf das Basissubstrat zwischen den orthografischen Projektionen zweier benachbarter zweiter Gate-Leitungen (3G2) auf das Basissubstrat angeordnet ist.

9. Anzeigefeld nach Anspruch 7, ferner umfassend eine Source-Ansteuerschaltung, wobei
ein Signalausgangsanschluss der Source-Ansteuerschaltung mit der Vielzahl von Datenleitungen (Da) verbunden ist und der Signalausgangsanschluss der Source-Ansteuerschaltung Datensignale für die Vielzahl von Datenleitungen (Da) im Zeitmultiplexverfahren innerhalb eines Zeilenabtastzyklus bereitstellt; und
das erste Stromleitungssegment (4VDD) einen dritten Erstreckungsabschnitt (4VDD3) umfasst, wobei eine orthografische Projektion des dritten Erstreckungsabschnitts (4VDD3) auf das Basissubstrat und die orthografische Projektion der Datenleitung (Da) auf das Basissubstrat sich mindestens teilweise überlappen.

10. Anzeigefeld nach Anspruch 7, wobei
der erste Anschluss des Ansteuertransistors (T3) mit einer Stromleitung (5VDD) verbunden ist;
die vierte leitfähige Schicht ferner einen ersten Verbindungsabschnitt (46) umfasst, wobei der erste Verbindungsabschnitt (46) zwischen zwei benachbarten ersten Stromleitungssegmenten (4VDD) in der ersten Richtung verbunden ist;
die fünfte leitfähige Schicht ferner die Stromleitung umfasst, wobei eine orthografische Projektion der Stromleitung auf das Basissubstrat sich entlang der zweiten Richtung erstreckt und die Stromleitung verwendet wird, um die stabile Spannungsquelle bereitzustellen.

11. Anzeigefeld nach Anspruch 7, wobei
das erste Stromleitungssegment (4VDD) ferner einen vierten Erstreckungsabschnitt (4VDD4) umfasst;
das Anzeigefeld ferner einen zweiten leitfähigen Abschnitt umfasst, wobei der zweite leitfähige Abschnitt mit dem Gate des Ansteuertransistors (T3) verbunden ist;
eine orthografische Projektion des vierten Erstreckungsabschnitts auf das Basissubstrat sich entlang der zweiten Richtung erstreckt und zwischen der orthografischen Projektion der Datenleitung (Da) auf das Basissubstrat und einer orthografischen Projektion des zweiten leitfähigen Abschnitts auf das Basissubstrat angeordnet ist.

12. Anzeigefeld nach Anspruch 1, wobei
der erste Anschluss des Ansteuertransistors (T3) mit einer Stromleitung verbunden ist, die Pixelansteuerschaltung ferner einen achten Transistor (T8) umfasst, ein erster Anschluss des achten Transistors (T8) mit dem Gate des Ansteuertransistors (T3) verbunden ist und das Anzeigefeld ferner umfasst:
ein Basissubstrat;
eine zweite aktive Schicht, die auf einer Seite des Basissubstrats angeordnet ist, wobei die zweite aktive Schicht einen aktiven Abschnitt umfasst und eine Teilstruktur des aktiven Abschnitts verwendet wird, um eine Kanalregion des achten Transistors (T8) zu bilden;
eine fünfte leitfähige Schicht, die auf einer dem Basissubstrat abgewandten Seite der zweiten aktiven Schicht angeordnet ist, wobei die fünfte leitfähige Schicht die Stromleitung umfasst und eine orthografische Projektion der Stromleitung auf das Basissubstrat eine orthografische Projektion des aktiven Abschnitts auf das Basissubstrat bedeckt.

13. Anzeigefeld nach Anspruch 1, wobei
der erste Anschluss des Ansteuertransistors (T3) mit einer Stromleitung (5VDD) verbunden ist und das Anzeigefeld ferner umfasst:
ein Basissubstrat;
einen zweiten leitfähigen Abschnitt, wobei der zweite leitfähige Abschnitt mit dem Gate des Ansteuertransistors (T3) verbunden ist;
eine fünfte leitfähige Schicht, die auf einer Seite des Basissubstrats angeordnet ist, wobei die fünfte leitfähige Schicht die Stromleitung (5VDD) umfasst und eine orthografische Projektion der Stromleitung (5VDD) auf das Basissubstrat eine orthografische Projektion des zweiten leitfähigen Abschnitts auf das Basissubstrat bedeckt.

14. Anzeigefeld nach Anspruch 1, wobei
der erste Anschluss des Ansteuertransistors (T3) mit einer Stromleitung (5VDD) verbunden ist und das Anzeigefeld ferner umfasst:
ein Basissubstrat;
eine fünfte leitfähige Schicht, die auf einer Seite des Basissubstrats angeordnet ist, wobei die fünfte leitfähige Schicht die Stromleitung (5VDD) und die Datenleitung (Da) umfasst und eine orthografische Projektion der Stromleitung (5VDD) auf das Basissubstrat und eine orthografische Projektion der Datenleitung (Da) auf das Basissubstrat sich entlang einer zweiten Richtung erstrecken;
eine Elektrodenschicht, die eine Vielzahl von Elektrodenabschnitten umfasst, wobei sich eine orthografische Projektion des Elektrodenabschnitts auf das Basissubstrat mit der orthografischen Projektion der Stromleitung (5VDD) auf das Basissubstrat und die orthografische Projektion der Datenleitung (Da) auf das Basissubstrat überlappen;
eine Pixeldefinitionsschicht, die auf einer dem Basissubstrat abgewandten Seite der Elektrodenschicht angeordnet ist, wobei eine Pixelöffnung, die zum Bilden einer lichtemittierenden Einheit verwendet wird, auf der Pixeldefinitionsschicht bereitgestellt ist, und eine orthografische Projektion der Pixelöffnung auf das Basissubstrat mit der orthografischen Projektion des Elektrodenabschnitts auf das Basissubstrat übereinstimmt.

15. Anzeigevorrichtung, umfassend das Anzeigefeld nach einem der Ansprüche 1 bis 14.

## Revendications

1. Panneau d'affichage, comprenant une pluralité de circuits de pilotage de pixel, dans lequel le circuit de pilotage de pixel comprend un transistor de pilotage (T3) et un quatrième transistor (T4), le quatrième transistor (T4) a une première borne connectée à une ligne de données (Da), une seconde borne connectée à une première borne du transistor de pilotage (T3), et une grille connectée à une première ligne de grille (G1), **caractérisé en ce que**
la pluralité de circuits de pilotage de pixel comprend un premier circuit de pilotage de pixel et un second circuit de pilotage de pixel ;
une capacité formée par la première ligne de grille (G1) et une structure équipotentielle d'une grille du transistor de pilotage (T3) dans le premier circuit de pilotage de pixel est C1, et une capacité formée par la première ligne de grille (G1) et la structure équipotentielle de la grille du transistor de pilotage (T3) dans le second circuit de pilotage de pixel est C2, où C1 n'est pas égale à C2.

2. Panneau d'affichage selon la revendication 1, comprenant en outre une pluralité d'unités d'émission de lumière, dans lequel
la pluralité d'unités d'émission de lumière comprend une première unité d'émission de lumière et une seconde unité d'émission de lumière ;
le premier circuit de pilotage de pixel est utilisé pour piloter la première unité d'émission de lumière, et le second circuit de pilotage de pixel est utilisé pour piloter la seconde unité d'émission de lumière ;
avec un même courant de pilotage, une luminosité de la première unité d'émission de lumière est inférieure à une luminosité de la seconde unité d'émission de lumière, et C1 est inférieure à C2.

3. Panneau d'affichage selon la revendication 2, comprenant en outre :
un substrat de base ;
une première couche active localisée sur un côté du substrat de base, dans lequel la première couche active comprend une troisième partie active (63), et la troisième partie active (63) est utilisée pour former une région de canal du transistor de pilotage (T3) ;
une première couche conductrice localisée sur un côté de la première couche active à l'écart du substrat de base, dans lequel la première couche conductrice comprend une première partie conductrice (11), une projection orthographique de la première partie conductrice (11) sur le substrat de base couvre une projection orthographique de la troisième partie active (63) sur le substrat de base, et la première partie conductrice (11) est utilisée pour former la grille du transistor de pilotage (T3) ;
une seconde partie conductrice agencée en correspondance avec la première partie conductrice (11), dans lequel la seconde partie conductrice est connectée à la première partie conductrice (11) correspondant à celle-ci, une aire de chevauchement entre une projection orthographique sur le substrat de base de la première ligne de grille (G1) et une projection orthographique sur le substrat de base de la seconde partie conductrice dans le premier circuit de pilotage de pixel est S1, et une aire de chevauchement entre la projection orthographique sur le substrat de base de la première ligne de grille (G1) et la projection orthographique sur le substrat de base de la seconde partie conductrice dans le second circuit de pilotage de pixel est S2, où S1 est inférieure à S2.

4. Panneau d'affichage selon la revendication 3, dans lequel
le circuit de pilotage de pixel comprend en outre un huitième transistor (T8), une première borne du huitième transistor (T8) étant connectée à la grille du transistor de pilotage (T3) ; et
le panneau d'affichage comprend en outre :
une seconde couche active localisée sur un côté de la première couche conductrice à l'écart du substrat de base, dans lequel la seconde couche active comprend une huitième partie active (88) et une neuvième partie active (89) connectées l'une à l'autre, et la huitième partie active (88) est utilisée pour former une région de canal du huitième transistor (T8), dans lequel
la neuvième partie active (89) est connectée à la première partie conductrice (11), la seconde partie conductrice comprend la neuvième partie active (89), et une aire de chevauchement entre la projection orthographique sur le substrat de base de la première ligne de grille (G1) et une projection orthographique sur le substrat de base de la neuvième partie active (89) dans le premier circuit de pilotage de pixel est plus petite qu'une aire de chevauchement entre la projection orthographique sur le substrat de base de la première ligne de grille (G1) et la projection orthographique sur le substrat de base de la neuvième partie active (89) dans le second circuit de pilotage de pixel.

5. Panneau d'affichage selon la revendication 3, dans lequel
la première couche conductrice comprend la première ligne de grille (G1), et la projection orthographique de la première ligne de grille (G1) sur le substrat de base s'étend le long d'une première direction ; et
la première ligne de grille (G1) comprend :
une pluralité de premières parties d'extension (G11), dans lequel les projections orthographiques de la pluralité de premières parties d'extension (G11) sur le substrat de base s'étendent le long de la première direction et sont espacées le long de la première direction ;
une pluralité de deuxièmes parties d'extension (G12), dans lequel les deuxièmes parties d'extension (G12) sont connectées entre des premières parties d'extension (G11) adjacentes dans la première direction, dans lequel
une taille dans une seconde direction de la projection orthographique de la première partie d'extension (G11) sur le substrat de base est plus petite qu'une taille dans la seconde direction d'une projection orthographique de la deuxième partie d'extension (G12) sur le substrat de base, dans lequel la première direction et la seconde direction se croisent ; et
la projection orthographique de la seconde partie conductrice sur le substrat de base et la projection orthographique de la deuxième partie d'extension (G12) sur le substrat de base se chevauchent au moins partiellement.

6. Panneau d'affichage selon la revendication 5, dans lequel
le circuit de pilotage de pixel comprend en outre un huitième transistor (T8), une première borne du huitième transistor (T8) est connectée à la grille du transistor de pilotage (T3), et le panneau d'affichage comprend en outre :
une seconde couche active localisée sur un côté de la première couche conductrice à l'écart du substrat de base, dans lequel la seconde couche active comprend une huitième partie active (88) et une neuvième partie active (89) connectées l'une à l'autre, et la huitième partie active (88) est utilisée pour former une région de canal du huitième transistor (T8), dans lequel
la neuvième partie active (89) est connectée à la première partie conductrice (11), la seconde partie conductrice comprend la neuvième partie active (89), une projection orthographique de la neuvième partie active (89) sur le substrat de base est localisée sur la projection orthographique de la deuxième partie d'extension (G12) sur le substrat de base ; et
une taille dans la première direction de la projection orthographique sur le substrat de base de la neuvième partie active (89) dans le premier circuit de pilotage de pixel est plus petite qu'une taille dans la première direction de la projection orthographique sur le substrat de base de la neuvième partie active (89) dans le second circuit de pilotage de pixel.

7. Panneau d'affichage selon la revendication 1, dans lequel
la pluralité de circuits de pilotage de pixel est agencée le long de la première direction et de la seconde direction, et
le panneau d'affichage comprend en outre :
un substrat de base ;
une quatrième couche conductrice localisée sur un côté du substrat de base, dans lequel la quatrième couche conductrice comprend une pluralité de premiers segments de ligne de puissance (4VDD), les premiers segments de ligne de puissance (4VDD) sont agencés en correspondance avec les circuits de pilotage de pixel, des projections orthographiques de la pluralité de premiers segments de ligne de puissance (4VDD) sur le substrat de base sont agencées le long de la première direction et de la seconde direction et s'étendent le long de la seconde direction, la première direction et la seconde direction se croisent, et les premiers segments de ligne de puissance (4VDD) sont connectés à une source de tension stable ;
une cinquième couche conductrice localisée sur un côté de la quatrième couche conductrice à l'écart du substrat de base, dans lequel la cinquième couche conductrice comprend la ligne de données (Da), et une projection orthographique de la ligne de données (Da) sur le substrat de base s'étend le long de la seconde direction.

8. Panneau d'affichage selon la revendication 7, dans lequel
le circuit de pilotage de pixel comprend en outre un huitième transistor (T8), une première borne du huitième transistor (T8) est connectée à la grille du transistor de pilotage (T3), et le panneau d'affichage comprend en outre :
une seconde couche active localisée entre la quatrième couche conductrice et le substrat de base, dans lequel la seconde couche active comprend une huitième partie active (88), et la huitième partie active (88) est utilisée pour former une région de canal du huitième transistor (T8) ;
une troisième couche conductrice localisée entre la seconde couche active et la quatrième couche conductrice, dans lequel la troisième couche conductrice comprend une seconde ligne de grille (3G2), une projection orthographique de la seconde ligne de grille (3G2) sur le substrat de base s'étend le long de la première direction et couvre une projection orthographique de la huitième partie active (88) sur le substrat de base, et une structure partielle de la seconde ligne de grille (3G2) est utilisée pour former une grille supérieure du huitième transistor (T8),
dans lequel la projection orthographique du premier segment de ligne de puissance (4VDD) sur le substrat de base est localisée entre les projections orthographiques de deux secondes lignes de grille (3G2) adjacentes sur le substrat de base.

9. Panneau d'affichage selon la revendication 7, comprenant en outre un circuit de pilotage de source, dans lequel
une borne de sortie de signal du circuit de pilotage de source est connectée à la pluralité de lignes de données (Da), et la borne de sortie de signal du circuit de pilotage de source fournit des signaux de données à la pluralité de lignes de données (Da) selon un mode de division temporelle au sein d'un cycle de balayage de rangée ; et
le premier segment de ligne de puissance (4VDD) comprend une troisième partie d'extension (4VDD3), dans lequel une projection orthographique de la troisième partie d'extension (4VDD3) sur le substrat de base et la projection orthographique de la ligne de données (Da) sur le substrat de base se chevauchent au moins partiellement.

10. Panneau d'affichage selon la revendication 7, dans lequel
la première borne du transistor de pilotage (T3) est connectée à une ligne de puissance (5VDD) ;
la quatrième couche conductrice comprend en outre une première partie de connexion (46), dans lequel la première partie de connexion (46) est connectée entre deux premiers segments de ligne de puissance (4VDD) adjacents dans la première direction ;
la cinquième couche conductrice comprend en outre la ligne de puissance, dans lequel une projection orthographique de la ligne de puissance sur le substrat de base s'étend le long de la seconde direction, et la ligne de puissance est utilisée pour fournir la source de tension stable.

11. Panneau d'affichage selon la revendication 7, dans lequel
le premier segment de ligne de puissance (4VDD) comprend en outre une quatrième partie d'extension (4VDD4) ;
le panneau d'affichage comprend en outre une seconde partie conductrice, la seconde partie conductrice étant connectée à la grille du transistor de pilotage (T3) ;
une projection orthographique de la quatrième partie d'extension sur le substrat de base s'étend le long de la seconde direction, et est localisée entre la projection orthographique de la ligne de données (Da) sur le substrat de base et une projection orthographique de la seconde partie conductrice sur le substrat de base.

12. Panneau d'affichage selon la revendication 1, dans lequel
la première borne du transistor de pilotage (T3) est connectée à une ligne de puissance, le circuit de pilotage de pixel comprend en outre un huitième transistor (T8), une première borne du huitième transistor (T8) est connectée à la grille du transistor de pilotage (T3), et le panneau d'affichage comprend en outre :
un substrat de base ;
une seconde couche active localisée sur un côté du substrat de base, dans lequel la seconde couche active comprend une partie active, et une structure partielle de la partie active est utilisée pour former une région de canal du huitième transistor (T8) ;
une cinquième couche conductrice localisée sur un côté de la seconde couche active à l'écart du substrat de base, dans lequel la cinquième couche conductrice comprend la ligne de puissance, et une projection orthographique de la ligne de puissance sur le substrat de base couvre une projection orthographique de la partie active sur le substrat de base.

13. Panneau d'affichage selon la revendication 1, dans lequel
la première borne du transistor de pilotage (T3) est connectée à une ligne de puissance (5VDD), et le panneau d'affichage comprend en outre :
un substrat de base ;
une seconde partie conductrice, la seconde partie conductrice étant connectée à la grille du transistor de pilotage (T3) ;
une cinquième couche conductrice localisée sur un côté du substrat de base, dans lequel la cinquième couche conductrice comprend la ligne de puissance (5VDD), et une projection orthographique de la ligne de puissance (5VDD) sur le substrat de base couvre une projection orthographique de la seconde partie conductrice sur le substrat de base.

14. Panneau d'affichage selon la revendication 1, dans lequel
la première borne du transistor de pilotage (T3) est connectée à une ligne de puissance (5VDD), et le panneau d'affichage comprend en outre :
un substrat de base ;
une cinquième couche conductrice localisée sur un côté du substrat de base, dans lequel la cinquième couche conductrice comprend la ligne de puissance (5VDD) et la ligne de données (Da), et une projection orthographique de la ligne de puissance (5VDD) sur le substrat de base et une projection orthographique de la ligne de données (Da) sur le substrat de base s'étendent le long d'une seconde direction ;
une couche d'électrode comprenant une pluralité de parties d'électrode, dans lequel une projection orthographique de la partie d'électrode sur le substrat de base chevauche la projection orthographique de la ligne de puissance (5VDD) sur le substrat de base et la projection orthographique de la ligne de données (Da) sur le substrat de base ;
une couche de définition de pixel localisée sur un côté de la couche d'électrode à l'écart du substrat de base, dans lequel une ouverture de pixel utilisée pour la formation d'une unité d'émission de lumière est fournie sur la couche de définition de pixel, et une projection orthographique de l'ouverture de pixel sur le substrat de base coïncide avec la projection orthographique de la partie d'électrode sur le substrat de base.

15. Dispositif d'affichage, comprenant le panneau d'affichage selon l'une quelconque des revendications 1 à 14.
